# EUROPÄISCHE PATENTANMELDUNG

(11) **EP 3 179 261 A1**
(43) Veröffentlichungstag der Anmeldung: **14.06.2017**
(21) Anmeldenummer: 16201557.2
(22) Anmeldetag: 30.11.2016
(51) Int. Cl.: G01R 31/36

(54) **ZUSTANDSINDIKATOR UND KOMMUNIKATIONSSYSTEM ZUR KONTROLLE VON AKKUMULATOREN SOWIE DAZUGEHÖRIGES ÜBERWACHUNGS- UND KOMMUNIKATIONSVERFAHREN**

(30) Priorität: 01.12.2015 DE 202015106539 U
(71) Anmelder: RP-Technik GmbH, 63110 Rodgau (DE)
(72) Erfinder: Eichler, Martin, 61350 Bad Homburg (DE); Ranostaj, Frank, 60437 Frankfurt am Main (DE)
(74) Vertreter: Cremer, Christian

(57) **Zusammenfassung**

Die vorliegende Erfindung beschäftigt sich mit einem Zustandsindikator, mit einem Kommunikationssystem, das einen Zustandsindikator und ein Erfassungssystem aufweist, sowie mit einem Verfahren zur Anzeige eines Zustands eines Akkumulators. Der Zustandsindikator umfasst eine Recheneinheit, eine Auswerteeinheit und mindestens eine einem Akkumulator zugeordnete Messeinrichtung, womit ein Akkumulator kontrollierbar ist, der auch als wieder-aufladbare Batterie bezeichnet werden kann. Eine Kontrolle bzw. Überwachung eines Akkumulators lässt sich besonders schnell und zuverlässig ausführen, wenn der Akkumulator mit einem Zustandsindikator verbunden ist. Besonders vorteilhaft ist der erfindungsgemäße Zustandsindikator, der anhand des von ihm erfassten Zustands einen Gesamteindruck zu dem von ihm überwachten Akkumulator vermitteln kann.

## Beschreibung

Die vorliegende Erfindung betrifft einen Zustandsindikator gemäß dem Oberbegriff von Anspruch 1, ein Kommunikationssystem gemäß dem Oberbegriff von Anspruch 13, das einen Zustandsindikator und ein Erfassungssystem aufweist, sowie ein Verfahren zur Anzeige eines Zustands eines Akkumulators nach dem Oberbegriff von Anspruch 17. Der Zustandsindikator umfasst eine Recheneinheit, eine Auswerteeinheit und mindestens eine, einem Akkumulator zugeordnete Messeinrichtung, womit ein Akkumulator kontrollierbar ist, der auch als wiederaufladbare Batterie bezeichnet werden kann.

Aus sprachlichen Vereinfachungen wird nachfolgend von Batterie oder Akkumulator gesprochen, obwohl die jeweilige Ausführung häufig auch auf den anderen Typ Energiespeicher, also auf Akkumulator statt Batterie und auf Batterie statt Akkumulator, anwendbar ist. Wo anwendbar, darf der Fachmann nachfolgend den einen Begriff wie Akkumulator durch den anderen Begriff wie Batterie substituieren.

### Stand der Technik

In der Schutzrechtsliteratur gibt es zahlreiche bzw. mannigfaltige Systembeschreibungen, die auf unterschiedlichste Arten eine Auskunft über eine zu überwachende Batterie oder einen zu überwachenden Akkumulator ermitteln und ggf. mitteilen wollen.

In den Druckschriften JPH 09 211 091 A1 (Inhaberin: MATSUSHITA ELECTRIC IND CO LTD; Anmeldetag: 07.02.1996), US 2013/257 382 A1 (Anmelderin: APPLE INC; Anmeldetag: 09.05.2012) und WO 2013/151 821 A2 (Anmelderin: APPLE INC; Prioritätstage: 02.04.2012 und 09.05.2012) werden Aspekte zu dem Thema "Management der Zyklen-Lebensdauer von aufladbaren Batterien" beschrieben. Das Management soll eine Überwachung eines Akkumulators hinsichtlich dessen Zyklenlebensdauer ermöglichen.

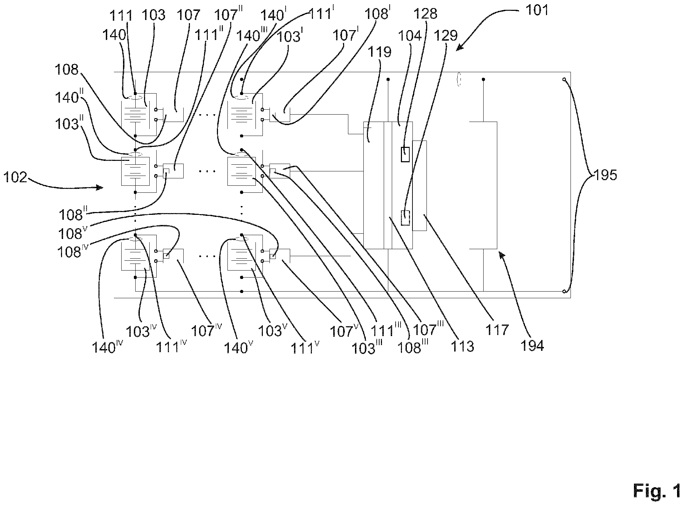

Die EP 2 846 394 B1 (Patentinhaberin: The Swatch Group Research and Development Ltd.; Anmeldetag: 10.09.2013) beschäftigt sich mit dem Thema, wie die Nutzungsdauer einer Batterie zu verlängern sein könnte. Hierfür wird eine elektronische Schaltung mit einem Oszillator vorgeschlagen, die einen Schalter umschalten kann, sodass die elektronische Schaltung am Ende der Batterielebenszeit die lieferbare Spannung mittels einem "Booster" anhebt (siehe Abs. [0018]). Signale der elektronischen Schaltung sollen kabelgebunden an das elektrische Gerät übertragen werden, für das die Batterie die Energie zur Verfügung stellt. Mit anderen Worten, die Schaltung, die das Betriebszeitende einer Batterie (EOL-Überwachung - siehe Abs. [0016]) anhand der Spannung der Batterie bestimmt, führt die Spannung im Bedarfsfall über eine DC-DC-Glied (vgl. Figur 1), das in dieser Betriebsphase auf die Leitung zum Verbraucher aufgeschaltet wird. Einige Komponenten der beschriebenen Schaltung lassen sich auch in der nachfolgend dargestellten Erfindung verwenden.

Die Patentschrift DE 60 204 009 142 T2 (Inhaberin: Matsushita Electric Industrial Co. Ltd.; Prioritätstage: 05.12.2003 und 07.05.2004) beschreibt eine Vorrichtung zur Steuerung des Ladevorgangs mit einem Zyklenspeicher.

Eine Überwachung einzelner Lade- und Entladezyklen ist in dem Batterieladesystem gemäß Anmeldeschrift US 2002/060 554 A1 (Anmelderin: IBM Corporation Intellectual Property Law Personal and Printing Systems Group; Prioritätstag: 26.04.2000) vorgesehen.

Die Patentanmeldung JP 2003 086 255 A (Inhaberin Toyota Motor Corp.; Anmeldetag: 12.09.2001) dürfte ein Verfahren zur Bestimmung eines Alterungszustands einer aufladbaren Batterie basierend auf elektrochemischen Parametern behandeln. In der DE 10 2006 000 397 A1 (Anmelderin: Toyota Jidosha K.K.; Prioritätstage: 08.08.2005 und 17.03.2006) ist das Thema der Alterungsbestimmung von der Anmelderin der JP 2003 086 255 A dahingehend weiterverfolgt worden, dass die Gestaltung zweier möglicher Anzeigen (vgl. Figuren 6 und 8) vorgeschlagen wird, durch die dem Fahrer eines batteriegetriebenen Fahrzeugs die (Rest-)Lebenserwartung der Batterie veranschaulicht werden kann.

Ein eher allgemeines Konzept zur Batterieüberwachung geht aus der Patentanmeldung US 2013/158 912 A1 (Anmelderin: Chung-Shan Institute of Science and Technology, Armaments, Bureau, Ministry of National Defense; Anmeldetag: 15.12.2011) hervor. Zur Auswertung der überwachten Parameter werden statistische Verteilungen analysiert (s. insbesondere Abs. [0012]).

Das in der Patentanmeldung US 2005/206 388 A1 (Erfinder: J. B. Quint, S. H. Dworkin; Anmeldetag: 10.05.2005) beschriebene Batteriemanagementsystem sieht ein automatisiertes System vor, das die gewonnenen Ergebnisse in konkrete Arbeitsanweisungen umsetzt, sodass z. B. abhängig von Testergebnissen Techniker gezielt instruiert werden können (s. insbesondere Abs. [0008]).

Die Idee des Signalisierens eines Ladezustands durch eine leuchtende oder blinkende LED geht z. B. aus der Beschreibung des Batterieladegeräts in der US 2008/290 839 A1 (Anmelderin: Canon Kabushiki Kaisha; Prioritätstag: 23.05.2007) hervor (s. z. B. Fig. 20). Gleichartig beschreibt die US 2013/342 342 A1 (Anmelderin: Hunter Capital Management Group, LLC; Anmeldetag: 20.06.2012), dass mittels des Signalisierens über unterschiedliche Leuchtfrequenzen einer LED der Betriebszustand einer Batterie bzw. das Ergebnis von Leuchtentests angezeigt werden können.

Aufgrund des vorgesehenen Einsatzortes eines Vagus-Nerv-Stimulators als im menschlichen Körper implantiertes elektrisches Gerät schlägt die EP 2 667 940 B1 (Patentinhaberin: Cyberonics, Inc.; Prioritätstag: 28.01.2011) vor, einen gesonderten, so genannten "Ausgabemechanismus" vorzuhalten, über den an tragbare Geräte wie an einen Laptop-Computer oder an einen PDA Anhaltspunkte und Hinweise zu dem Betrieb des Vagus-Nerv-Stimulators inklusive dem Batteriezustand geliefert werden können.

Das Dokument JP 2006 312 528 A (Anmelderin: Mitsubishi Electric Corp.; Anmeldetag: 09.05.2005) betrifft ein Energiespeichergerät für einen Fahrstuhl, mit dem die Alterung der Fahrstuhlbatterie abgeschätzt und zur Information ausgegeben werden kann (s. insbesondere Abs. [0001]). Zur Bestimmung der Alterung im Betrieb wird eine Temperaturerfassung durchgeführt (s. insbesondere Abs. [0007]). Zusätzlich kann ein Ladestrom überwacht werden (s. insbesondere Abs. [0009]). Die Alterung wird durch eine Gleichung bestimmt (s. Abs. [0018]). Wenn der berechnete Wert, der für die Alterung steht, einen Grenzwert überschreitet, wird ein Warnsignal ausgegeben (s. insbesondere Abs. [0018]).

Ein ähnliches Konzept, allerdings für portable Batteriesysteme, scheint in der Patentanmeldung JP 2009 193 919 A (Anmelderin: Panasonic Corp.; Anmeldetag: 18.02.2008) beschrieben zu sein (vgl. Abs. [0001]). Zusätzlich zu Temperatureinflüssen wird das Laden und das Entladen als ein sich auf die Alterung der Batterien auswirkender Effekt benannt (s. Abs. [0005]). Diese Druckschrift betrifft spezifisch wasserfreie Sekundärbatterien (s. Abs. [0005]). Für Berechnungen einer verbleibenden Lebensdauer werden eine Alterung durch Betriebszeiten und eine Alterung durch Standzeiten unterschieden (s. Abs. [0009]). Außerdem wird die Leerlaufspannung überwacht (s. Abs. [0019]). Auch soll die Spannung der Batterie ganz allgemein ein Ausdruck für die Alterung im Betrieb sein (vgl. Abs. [0019]). Es ist vorgesehen, die verbleibende Lebensdauer anzuzeigen (s. Abs. [0049]). Die verbleibende Lebensdauer soll als Wert einer Anzahl von Tagen ausgegeben werden (s. Abs. [0067]). Um einen Betriebszustand festzustellen, können in einer zweiten Ausführungsform positive und negative Lade- und Entladeströme festgestellt werden (s. Abs. [0081]). Als mögliche Anwendungsbereiche für das in der JP 2009 193 919 A vorgestellte Überwachungs- und Abschätzungsverfahren zum Batteriezustand werden z. B. elektrische Autos sowie "Backup"-Energieversorgungssysteme genannt.

Die Patentanmeldung JPH 09 269 360 A (Anmelderin: Shindengen Electric MFG; Anmeldetag: 29.03.1996) betrifft eine unterbrechungsfreie Energieversorgung, die über das "Timing" des Batteriewechsels informiert (s. Abs. [0001]). Gemäß Abs. [0006] soll eine Lebensdauer auf Grundlage einer Zyklentabelle berechnet werden. Die Ausgabe eines Alarms kann aufgrund verschiedener Faktoren erfolgen, einschließlich des Erreichens eines bestimmten Abschnitts im Zyklenleben (s. Abs. [0015]).

In der Patentschrift EP 1 213 817 B1 (Inhaberin: Francotyp-Postalia GmbH; Prioritätstag: 11.12.2000) wird eine Lebensdauerüberwachung von Bauteilen bzw. Modulen beschrieben (s. insbesondere Abs. [0006]). Gemäß Abs. [0008] wird hierfür eine Parametergröße gemessen und deren Einfluss auf eine mittels einer Zähltechnik bestimmte Lebenszeit bestimmt, wobei ein Zählstand modifiziert wird, sodass dieser sich einer für das Bauteil spezifischen Ausfallschwelle nähert. Eine Warnung soll von dem Gerät ausgegeben werden, bevor das Lebensdauerende des Bauteils erreicht wird. Als Beispiel einer geeigneten Anwendung des anfänglich eher abstrakter dargestellten Überwachungsverfahrens wird im gleichen Absatz [0008], genauer in den Zeilen 37 ff., eine Batterieüberwachung erläutert.

Ähnlich wie in den zuvor vorgestellten Dokumenten beschreibt die EP 2 345 904 B1 (Patentinhaberin: Coronis SAS; Anmeldetag: 11.01.2010), dass in Abhängigkeit von Ereignissen ein globaler Lebenszähler, der die Restlebensdauer einer Batterie ausdrückt, und mehrere Ereignisüberwachungszähler dekrementiert werden können.

In der Patentschrift US 4 803 416 B (Erfinder: J. Abiven, E. Audrain; Anmeldetag: 20.08.1986) ist vorgesehen, in Abhängigkeit einer Anzahl vorgegebener Lade- und Entladezyklen und einer Anzahl und einer Tiefe dieser Zyklen sowie deren Einfluss auf die Alterung der Batterie unter Einbeziehung der Temperatur ein geschätztes Lebensdauerende zu bestimmen und ggf. eine Warnung auszugeben (s. Spalte 3, Zeilen 2 bis 7).

Wie aus der Zusammenstellung für einen Fachmann zu entnehmen ist, möchte die Fachwelt schon seit langem wissen, wie es um den Zustand von Batterien steht, die sich insbesondere in Betrieb befinden oder die zur Versorgungssicherheit vorgehalten werden. Dabei werden auch immer wieder verschiedene Übertragungsverfahren vorgestellt. Zur Einschätzung des Gesundheitszustands eines Akkumulators oder einer Batterie wird im Laufe der Jahre offensichtlich mit immer komplizierteren Auswertemethoden operiert. Viele der Methoden setzen bei der Analyse der Ladungszustände an. Die zunehmenden Berechnungs- und Überwachungskapazitäten und die damit einhergehenden Möglichkeiten, umfangreichere Berechnungen vornehmen zu können, werden anscheinend gerne vollumfänglich von den Entwicklern von Batterieüberwachungssystemen genutzt und eingesetzt. Die Komplexität solcher Systeme darf augenscheinlich immer weiter steigen. Ob der Erkenntnisgewinn damit für den Benutzer solcher Anlagen zunimmt, mag für praxisorientierte Servicetechniker zum Teil nicht nachvollziehbar sein.

### Aufgabenstellung

In dieser Situation besteht ein Bedarf in der Fachwelt nach Überwachungssystemen von Akkumulatoren, die bei einer überschaubaren Komplexität verlässliche Ergebnisse liefern. Einer an einer Überwachung von Akkumulatoren interessierten Person sollen einfach handhabbare Mittel bereitgestellt werden, um eine gute Einschätzung über die Eignung eines Akkumulators für einen weiteren Betrieb treffen zu können.

### Erfindungsbeschreibung

Die erfindungsgemäße Aufgabe wird durch einen Zustandsindikator nach Anspruch 1 gelöst, der in ein Kommunikationssystem gemäß Anspruch 13 eingebunden sein kann. Ein günstiges Verfahren, durch das der Zustand eines Akkumulators der Umwelt bekannt gegeben wird, ist dem Anspruch 17 zu entnehmen. Vorteilhafte Weiterbildungen lassen sich den abhängigen Ansprüchen entnehmen.

In der Fachwelt wird häufig von Batterien und von Akkumulatoren in synonymer Verwendung der beiden Begriffe gesprochen. Der Begriff "Batterie" wird verwendet, obwohl ein Akkumulator gemeint ist, und auch andersherum. Dementsprechend verwendet die vorliegende Erfindungsbeschreibung einen der beiden Begriffe an vielen Stellen in dem Text an Stelle des Ausdrucks "Batterie(n) und/oder Akkumulator(en)".

Eine Kontrolle bzw. Überwachung eines Akkumulators lässt sich besonders schnell und zuverlässig ausführen, wenn der Akkumulator mit einem Zustandsindikator verbunden ist. Der Akkumulator dient als Zwischenspeicher für elektrische Energie und kann insbesondere elektrischen Strom bei gleichzeitigem Vorhalten einer Akkumulatorspannung für einen Verbraucher bereitstellen. Der Akkumulator kann an einer Stromquelle wieder aufgeladen werden.

Besonders hilfreich ist eine Überwachung eines Akkumulators durch einen Zustandsindikator, wenn der Akkumulator eine Vielzahl von Lade- und Entladezyklen durchfährt. Gebräuchliche Akkumulatoren, wie Bleiakkumulatoren oder Lithium-Ionen-Akkumulatoren sind bekannt dafür, dass sie sich für zahlreiche Lade- und Endladezyklen eignen. Die Möglichkeit einer Überwachung von Akkumulatoren, die in einem Sicherheitssystem zum Einsatz kommen, z. B. als Speicher einer Notstromversorgung, ist von besonderem Interesse. Sicherheitsüberprüfungen über den Zustand eines Akkumulators können mit einem Zustandsindikator besonders einfach ausgeführt und daher zur Sicherheit auch häufig wiederholt werden.

Der Zustandindikator kann z. B. so gestaltet sein, dass er einen Zustand des von ihm überwachten Akkumulators anzeigt bzw. indiziert. Besonders vorteilhaft ist ein Zustandsindikator, der anhand des von ihm erfassten Zustands einen Gesamteindruck zu dem von ihm überwachten Akkumulator vermitteln kann.

Der Zustandsindikator ist mehrkomponentig aufgebaut. Der Zustandindikator umfasst eine Auswerteeinheit. Der Zustandsindikator umfasst eine Recheneinheit. Bedarfsgerecht können weitere Einheiten vorhanden sein. Z. B. eine oder mehrere Eingangsstufen zur Umwandlung von Messsensordaten in verarbeitbare Messsignale können in dem Zustandsindikator vorhanden sein. Eine weitere Komponente des oder für den Zustandsindikator kann eine Messeinrichtung sein.

In einer Ausgestaltung ist eine Recheneinheit als eine Prozessoreinheit realisiert, in der auf Grundlage von einem oder mehreren Rechenprogrammen aus Eingangswerten bzw. Eingangsdaten Ausgangswerte bzw. Ausgangsdaten generiert werden. Hierbei kann eine Verknüpfung mehrerer, vorhandener Werte bzw. Daten erfolgen. In der Recheneinheit sind sowohl arithmetische als auch logische Operationen, generell mathematische Operationen ausführbar.

Wie gesagt, der Zustandsindikator weist eine Auswerteeinheit auf. Die Auswerteeinheit kann zumindest in Teilen als elektronische Schaltung oder als Datenverarbeitungsprogramm bereit stehen, wobei das Datenverarbeitungsprogramm zum Beispiel auf der Recheneinheit ausführbar sein kann. Für die Auswerteeinheit sind Daten, wie Zustandsmessdaten, aufnehmbar. Die Daten können aufbereitet werden, um in einem für die Auswertung geeigneten Format, z. B. als Zahlenwert, vorzuliegen. Eine Form von Zustandsmessdaten sind Temperaturmessdaten. Es können verschiedene Zustandsmessdaten gemessen bzw. ermittelt werden, um einen Akkumulatorzustand für ein zu bildendes Ergebnis der Überwachung in Erfahrung zu bringen. Ein Zustandsmessdatum oder eine Folge von Zustandsmessdaten können von einer Messeinrichtung aufgenommen und an die Auswerteeinheit weitergeleitet werden.

In einer Ausgestaltung ist der Zustandsindikator zumindest mit mindestens einer Messeinrichtung verbunden. Die Messeinrichtung ist dem Akkumulator zugeordnet. In einer weiteren Ausgestaltung ist eine Messeinrichtung Teil des Zustandsindikators. Mischformen sind ebenfalls vorstellbar und realisierbar. Eine Messeinrichtung kann z. B. an einen Akkumulator oder einen Akkumulatorpol aufgesteckt oder angeschraubt sein. Die Messeinrichtung kann Zustandsmessdaten eines Akkumulators oder einer Akkumulatorumgebung kontinuierlich oder auf Abfrage bereitstellen. Es ist auch möglich, Zustandsmessdaten nach einem vorgebbaren Zeitplan von der Messeinrichtung auf die Auswerteeinheit zu übertragen. Beispielsweise können stündlich Zustandsmessdaten gemessen bzw. für die weitere Verarbeitung zur Verfügung gestellt werden. Die Zustandsmessdaten, die der Auswerteeinheit bereitgestellt sind, können nach verschiedenen Kriterien oder Algorithmen ausgewertet werden. Beispielsweise können Zustandsmessdaten von Temperaturmessungen, wie Temperaturwerte, die als Spannungswerte von der Messeinrichtung bereitgestellt werden, umgerechnet werden.

Besonders vorteilhaft ist es, wenn der Zustandsindikator einen Taktgeber umfasst. Der Taktgeber ist vorzugsweise von der Recheneinheit direkt oder indirekt ansteuerbar. D. h., zumindest ein Wert der Recheneinheit kann dazu verwendet werden, dem Taktgeber einen Wert vorzugeben. Durch den Taktgeber können z. B. Spannungsänderungen in einer zeitlichen Folge bereitgestellt werden. In einer Ausgestaltung ist als ein Taktgeber ein Pulsfrequenzgenerator gewählt. In einer ähnlichen Ausgestaltung ist der Taktgeber durch einen Pulsgenerator realisiert. Durch einen Pulsfrequenzgenerator kann eine vorgebbare Pulsform mit einer Frequenz, also mit einer Folge von vergleichbaren Pulsformen, als ein Pulszug generiert werden. Der Pulszug ist vorzugsweise elektronisch ausgebbar. Der Pulszug ist idealerweise so gestaltet, dass er geeignet ist, eine Leistungsaufnahme eines Verbrauchers zu liefern. Es ist auch möglich, den Pulsfrequenzgenerator mit einer Leistungsstufe zu verbinden, um eine für den Verbraucher erforderliche Leistung anbieten zu können. In dem Zustandsindikator dient der Taktgeber der Versorgung Ausgabevorrichtung, wie einer optischen und/oder einer akustischen Ausgabevorrichtung. Mindestens eine Ausgabevorrichtung ist vorhanden. Es können auch mehrere optische oder akustische Ausgabevorrichtungen vorhanden sein. Der Taktgeber erzeugt ein elektrisches Signal. Das elektrische Signal ist der Ausgabevorrichtung zuführbar. Eine Taktinformation, wie eine Frequenz des Taktgebers, die als elektrisches Signal vorliegt, kann von der Ausgabevorrichtung in ein optisches oder akustisches Signal gewandelt werden. Insbesondere ist das Signal unmittelbar für eine menschliche Wahrnehmung, wie z. B. für ein Sehen, geeignet. Es ist möglich, die optische oder akustische Ausgabe erst nach einer Übertragungszeit bzw. einem Übertragungsweg in eine für die menschlichen Sinne geeignete Form zu verbringen bzw. umzuwandeln (z. B. durch indirekte akustische Resonanzen).

Für die Recheneinheit kann ein Rechenprogramm vorgehalten werden. Das Rechenprogramm ist so gestaltet, dass es auf der Recheneinheit zur Ausführung kommen kann. Das Rechenprogramm ist auf die Recheneinheit bzw. auf einem Speicher für die Recheneinheit aufspielbar.

Eine der Aufgaben des Rechenprogramms ist es, eine Lebenszahl zu berechnen. In die Berechnung der Lebenszahl geht wenigstens ein Zustandsmessdatum ein, das einen Akkumulator betrifft bzw. für den Zustand wie die Gesundheit eines Akkumulators steht. Das Rechenprogramm verarbeitet mindestens einen Batteriekennwert. Der Batteriekennwert liegt z. B. abgespeichert, vorzugsweise in dem Zustandsindikator, vor. Der Batteriekennwert kann aber auch ein aktuell, im Moment der weiteren Auswertung gemessener Wert sein. Ein Batteriekennwert kann z. B. eine Akkumulatorkennung sein. Als ein geeigneter Batteriekennwert kann eine Sollbetriebstemperatur, eine anfängliche Ladekapazität, eine Nennspannung oder ein Leistungsabgabewert sein. Auch eine Kombination aus den zuvor genannten Batteriekennwerten bzw. Batteriekenngrößen kann sinnvollerweise kombiniert zu einem Batteriekennwert verbunden werden.

Eine Lebenszahl ist z. B. in Stunden, Tagen oder Monaten dimensionierbar. Die Lebenszahl kann in einer Größenordnung berechnet werden, durch die in einer ein- bis dreistelligen Zahl die Gesamtlebensdauer ausdrückbar ist, z. B. in Wochen oder in Monaten. Eine günstige Angabe der Lebenszahl kann insbesondere durch eine Ladezyklenzahl bestimmt werden. Üblicherweise übersteht eine Batterie eine gewisse Anzahl an Ladezyklen. D. h., die Batterie kann mehrfach wieder aufgeladen werden. Irgendwann verschlechtert sich das Ladeverhalten der Batterie. In dem Fall neigt sich die Batterie dem Zyklenende. Die einzelnen Ladezyklen können nachverfolgt und registriert werden. Die maximale Anzahl möglicher Zyklen ist irgendwann erreicht. In einer geeigneten Konfiguration wird durch die Ladezyklenzahl die Anzahl der möglichen Ladungsvorgänge zum Ausdruck gebracht. In einer anderen Konfiguration wird durch die Ladezyklenzahl die Anzahl der schon vorgenommenen bzw. durchlaufenen Ladezyklen hinterlegt. Die Lebenszahl ist einer einem Empfänger bekannten physikalischen Größe zuordnenbar.

Die Lebenszahl ist u. a. dazu geeignet, in dem Zustandsindikator weiterleitbar zu sein. Die Lebenszahl liegt als ein elektrisches Signal vor. Die Lebenszahl wird dem Taktgeber zugeführt. Der Taktgeber nimmt das elektrische Signal der Lebenszahl auf. Der Zustandsindikator umfasst weiterhin eine Ausgabevorrichtung. Der Taktgeber wandelt die Lebenszahl in ein für die Ausgabevorrichtung geeignetes elektrisches Signal. Die Ausgabevorrichtung wird über den Taktgeber mit der Lebenszahl versorgt. Die Ausgabevorrichtung dient einer weiterführenden Übertragung der Lebenszahl auf einem optischen oder akustischen Weg. Die Ausgabevorrichtung ist ein Signalwandler. Ein von der Ausgabevorrichtung abgebbares optisches oder akustisches Signal kann zu einem Empfänger gelangen. Ein Empfänger ist insbesondere ein Gerät, das zur Aufzeichnung von durch die Ausgabevorrichtung abgegebenen Signalen ausgestattet ist. Damit kann eine Übertragung einer Lebenszeit eines Akkumulators nahezu fehlerfrei durch den Zustandsindikator erfolgen.

Besonders vorteilhaft arbeitet ein Zustandsindikator innerhalb eines Kommunikationssystems. Ein Kommunikationssystem ist ein System, in dem Informationen zwischen verschiedenen Stationen austauschbar sind. Zusätzlich zu einem Zustandsindikator ist in einem Kommunikationssystem mindestens ein Erfassungssystem hilfreich.

Ein besonders vorteilhafter Zustandsindikator ist so gestaltet, dass die Übertragung der Lebenszahl sowohl durch menschliche Sinne als auch durch ein Erfassungssystem aufnehmbar und ggf. auswertbar ist.

Das Erfassungssystem arbeitet besonders störungsarm, wenn es ein eigenständiges System ist. Es kann auch gesagt werden, dass das Erfassungssystem von dem Akkumulator oder von der Recheneinheit des Zustandsindikators abgesetzt ist. Die elektronischen Komponenten des Erfassungssystems und der Rechercheeinheit des Zustandsindikators sind entkoppelt. Informationen zwischen dem Zustandsindikator und dem Erfassungssystem werden vorzugsweise leitungsungebunden, insbesondere elektromagnetisch oder akustisch, übertragen. Zumindest vorteilhaft ist ein optisches oder akustisches Übertragungsmedium in Form von Schalwellen oder Lichtwellen, weil damit auch einer überwachenden Person unmittelbar erkennbar wird, dass ein Zustand indiziert wird, den es zu erfassen gilt. Die Erfassung des Zustands des Akkumulators erfolgt, anders gesagt, durch ein Erfassungssystem, das unabhängig von dem Akkumulator ist. Das Erfassungssystem weist eine elektrische Energieversorgung auf. Die elektrische Energieversorgung des Erfassungssystems ist von mindestens einem zu überwachenden Akkumulator getrennt.

Das Erfassungssystem weist einen Sensor auf. Der Sensor ist vorzugsweise ein optischer oder akustischer Sensor. Das Erfassungssystem umfasst eine Anzeige. Eine Anzeige kann z. B. als Zeiger oder als ein Skalenbalken gestaltet sein. Besonders vorteilhaft ist eine Textbildanzeige, die einer Darstellung eines Zustands eines Akkumulators unter verschiedenen wählbaren Gesichtspunkten ermöglicht.

Der Sensor des Erfassungssystems ist dafür ausgelegt, eine bereitgestellte Signalfrequenz zu erfassen. Die Signalfrequenz liefert der Taktgeber des Zustandsindikators. Die Signalfrequenz ist vorzugsweise eine optische oder akustische Signalfrequenz. Die Signalübermittlung erfolgt vorzugsweise in einem Frequenzinterval. Das Frequenzinterval weist eine Maximalfrequenz auf, die insbesondere durch eine Spezifikation des Taktgebers begrenzt ist. Es ist möglich, dem Taktgeber ein Frequenzinterval zur Bereitstellung einer Signalfrequenz vorzugeben. Damit kann sichergestellt werden, dass die Signalfrequenz durch den Sensor detektierbar ist. Der Sensor arbeitet vorzugsweise mit einer Zeitkonstante, die eine Erholung des Sensors erlaubt, bevor ein zweiter Puls auf den Sensor trifft. Eine Abtastungsrate des Sensors beträgt vorzugsweise mindestens das 1,5-fache einer Maximalfrequenz des Taktgebers.

Eine detektierte Signalfrequenz kann in dem Erfassungssystem rechnerisch aufbereitet werden. Es ist möglich, eine Signalfrequenz durch eine Kehrwertbildung oder einen Skalierungsfaktor in eine gewünschte Größe umzurechnen. Die Signalfrequenz kann auch in eine Umrechnungsformel eingehen, die z. B. eine physikalische Beziehung zwischen mindestens einem Batteriekennwert und einer Signalfrequenz enthält. Eine weitere Möglichkeit besteht darin, in dem Erfassungssystem eine Tabelle vorzuhalten. Die Tabelle kann dazu genutzt werden, eine Signalfrequenz in eine Lebenszeitzahl umzurechnen. Die Lebenszeit, insbesondere in Form einer Lebenszeitzahl, ist vorzugsweise durch die Anzeige darstellbar. Für die Darstellung einer Lebenszeitzahl können auf dem Erfassungssystem grafische Module vorgehalten sein, die die Lebenszeitzahl in einer gewünschten Formatierung, z. B. durch eine farbliche Unterlegung, zur Anzeige bringen.

Wird der Zustandsindikator nun, insbesondere in einem zuvor beschriebenen Kommunikationssystem, betrieben, so zeigt der Zustandsindikator an, wie es um den Akkumulator bestellt ist. Besonders bevorzugt werden bei Notlichtbeleuchtungsanlagen Blei-Gel-Akkumulatoren, Lithium-Ionen-Akkumulatoren und/oder Lithium-Titanat-Akkumulatoren eingesetzt. Bei solchen Akkumulatoren möchte ein Service-Techniker schnell und auf einfachem Wege wissen, wie es um den Akkumulator bestellt ist. Dank der angebotenen Kommunikationsschnittstellen zwischen Zustandsindikator und dem Erfassungssystem, z. B. über eine akustische Verbindung, z. B. über eine optische Verbindung und/oder z. B. über eine Bluetooth-Verbindung, kann die mit der Überwachung betraute Person zügig zu einer Einschätzung gelangen, ob der Akkumulator, insbesondere für einen Weiterbetrieb bis zu einem nächsten Wartungsintervall, in Betrieb bleiben darf. Der Zustandsindikator gibt eine Lebenszahl bekannt. In die Berechnung der aktuellen Lebenszahl geht wenigstens ein Zustandsmessdatum ein. Das Zustandsmessdatum ist Teil einer Berechnung zur Ermittlung der im Moment noch gegebenen Lebenszahl des Akkumulators. Auf Basis von Erfahrungswerten und auf Basis von Betriebsführungen des Akkumulators kann so die Restlebenserwartung prognostiziert werden. Das Prognoseergebnis wird auf eine einfache und insbesondere eingängige Weise bekannt gemacht.

Der Zustandsindikator ist durch die zahlreichen Maßnahmen ein einfaches, kompaktes, aber zugleich aussagekräftiges Gerät, das zu der von ihm überwachten Batterie einem Beobachter oder Empfänger komprimiert Informationen zur Verfügung stellt.

Nachfolgend werden vorteilhafte Ausgestaltungen und Weiterbildungen dargelegt, die für sich gesehen, sowohl einzeln aus auch in Kombination, ebenfalls erfinderische Aspekte offenbaren können.

Eine oder die Lebenszahl (des Akkumulators) kann besonders vorteilhaft als eine Pulsfrequenz übertragen werden. Zur Übertragung erfolgt eine Wandlung eines elektrischen Signals, das die Lebenszahl enthält, in eine Pulsfrequenz. Die Wandlung der Lebenszahl ist vorzugsweise in einem Rechenprogramm ausführbar. Es ist möglich, dass die Wandlung in mehreren Stufen erfolgt, anders gesagt, dass das Rechenprogramm sich aus verschiedenen, aneinander anschließenden Schritten und Programmstufen zusammensetzt, durch die schrittweise die Lebenszahl und eine der Lebenszahl zugeordneten Pulsfrequenz errechnet werden.

Durch Verwendung einer Spannungsherabsetzungsschaltung in dem Zustandsindikator ist es möglich, den Zustandsindikator mit Akkumulatoren zu verbinden, deren Nennspannung höher ist, als eine Betriebsspannung des Zustandsindikators. Dadurch kann ein Zustandsindikator flexibel eine zum Betrieb erforderliche elektrische Energie kontrollieren. Die Energie kann hierfür vorgesehenen Akkumulatoren entnommen werden.

Der Einbau eines Zustandsindikators wird noch stärker vereinfacht dadurch, dass der Zustandsindikator einen stromfluss- bzw. stromflussrichtungskontrollierenden Vorschaltkreis aufweist. Der Vorschaltkreis dient als Bindungsglied oder Bindungsbaugruppe, also als elektrische Verbindung zum Akkumulator. Besonders einfach lässt sich ein Zustandsindikator einsetzen, der eine Graetzschaltung aufweist. Durch die Graetzschaltung wird der Zustandsindikator unabhängig gegenüber einem Vertauschen einer Plus-Minuspolung. Eine Graetzschaltung kann auch als Gleichrichterbrückenschaltung realisiert sein. Die Schaltung umfasst vorzugsweise vier Dioden. Unabhängig von der tatsächlich gewählten Verpolung kann der Zustandsindikator arbeiten. Der Zustandsindikator ist nicht auf die richtige Verpolung angewiesen. Der Zustandsindikator kann seine Funktion ausüben, obwohl bzw. gerade weil der Monteur des Zustandsindikators nicht besondere Sorgfalt walten lassen muss.

Eine besonders kompakte Ausführungsform eines Zustandsindikators weist einen Mikrocontroller auf. In einer Ausgestaltung umfasst der Mikrocontroller die Recheneinheit und den Taktgeber. Insbesondere zur Aufnahme von Messwerten kann der Zustandsindikator mindesten einen Analog-Digital-Konverter aufweisen. Auch die Analog-Digital-Konverter kann Teil des Mikrocontrollers sein. Geeignete integrierte Schaltkreise für einen einzusetzenden Mikrokontroller können ein PIC 10F 322 (Hersteller: Microchip Technology Inc.), ein PIC 16F 688 (Hersteller: Microchip Technology Inc.) sowie ein Mikrokontroller der LPC 800 - Serie (Hersteller: NXP Semiconductors N. V.) sein. Der Konverter liefert Messwerte digitalisiert zum Mikrokontroller. Beispielsweise ist eine Akkumulatorspannung digital konvertierbar und dem Mikrokontroller zuführbar. Vorzugsweise wird eine Spannung konvertiert, die von der Spannungsherabsetzungsschaltung kommt. Als zentraler Baustein einer Spannungsherabsetzungsschaltung kommt ein Linear-Regler, wie ein LT2951 (Hersteller: Texas Instruments Inc.), ein LM7805 (Hersteller: Texas Instruments Inc.) oder ein LM317 (Hersteller: Texas Instruments Inc.), infrage. Es ist auch möglich bzw. als eine Alternative möglich, zur Spannungsherabsetzung einen DC/DC-Wandler, wie einen TC962 (Hersteller: Microchip Technology Inc.), zu benutzen. Damit lassen sich Messwerte besonders gut weiter verarbeiten und - gleichermaßen - ist der Zustandsindikator vor Überspannungen geschützt.

Ein elektronischer Speicher könnte z. B. als EEPROM oder als Flash realisiert werden. Eine Möglichkeit wäre z. B. ein 1-Draht-EEPROM für 1 kilo-Byte, wie ein AT21CS01 oder ein AT21CS11 (Hersteller: Atmel Corporation). Eine Möglichkeit für einen seriellen Flash ist ein SST25VF032B (Hersteller: Microchip Technology Inc.). In dem elektronischen Speicher als Komponente des Zustandsindikators können Zahlenwerte, auch als Datum zu bezeichnen, abgelegt sein. Diese Zahlenwerte stehen für Berechnungen in der Recheneinheit zur Verfügung. Der Zustandsindikator weist einen Lebenszähler auf, dem zu Beginn einer Akkumulator- bzw. Batterielebensphase ein Startwert zugeordnet ist. Ein Startwert des Lebenszählers ist ein fester Wert, der in Abhängigkeit einer vergangenen Zeit oder in Abhängigkeit von eingetretenen Ereignissen vorzugsweise regelmäßig veränderbar ist. Für den Lebenszähler kann aus dem Speicher zu Beginn der Akkumulatorlebensphase ein fester Wert abgerufen werden. In einer Akkumulatorlebensphase können ein Ereignis oder mehrere Ereignisse stattfinden, die den Lebenszyklus des Akkumulators beeinflussen. Bei Eintritt eines Lebenszyklenereignisses ist eine in dem Speicher vorgehaltene Zykluszahl durch die Recheneinheit aktualisierbar. Eine Aktualisierung kann z. B. bei einer Akkumulatoraufladung oder einer Akkumulatorentladung, insbesondere über einen vorgebbaren Schwellenwert hinweg, festgestellt werden. Die Lebenszahl ist veränderbar. Ereignisse und deren Bedeutung für die Lebenszahl werden als Veränderungen in die Lebenszahl eingerechnet. Die Lebenszahl kann insbesondere auf Grundlage einer Zyklenzahl berechnet bzw. neu berechnet werden. In die Berechnung der Lebenszahl durch die Recheneinheit finden Zustandsmesswerte Eingang. Es können eine Mehrzahl von Zustandsmesswerten für die Berechnung der Lebenszahl verwendet werden, die zu verschiedenen Zeitpunkten festgestellt worden sind. Die Aufgabe erfolgt mittels Pulsfrequenz durch einen optischen oder akustischen Indikator. Damit ist die Lebenszahl besonders präzise bestimmbar. Somit ist die Lebenszahl deutlich anzeigbar.

Der Zustandsindikator kann mindestens eine Spannungsmesseinrichtung aufweisen. Anhand eines überwachten Spannungsverlaufs lässt sich ein Akkumulatorzustand besonders gut nachverfolgen. Zur Spannungsmessung wird das Potential wenigstens eines Akkumulatorpols abgegriffen. Eine Spannung kann zwischen dem einen Akkumulatorpol und einem Bezugspotential, z. B. einem zweiten Akkumulatorpol, gemessen werden. Von der Recheneinheit ist eine Entladetiefe des Akkumulators mithilfe der Spannungsmesseinrichtung bestimmbar. Bei bestimmten Akkumulatortypen, z. B. Bleiakkumulatoren mit Flüssigelektrolyten oder z. B. bei Lithium-Ionen-Akkumulatoren, kann eine (einen Grenzwert unterschreitende) Entladetiefe negativ auf eine Batterie- bzw. Akkumuatoralterung auswirken. Eine Gewichtung für die tatsächlich eingetretene Entladetiefe ist berechenbar. Die Entladetiefe ist umrechenbar, wobei eine Batteriealterung summarisch aus den erhaltenen Beiträgen abspeicherbar und für eine Berechnung der Lebenszeit verwendbar ist. Damit ist es möglich, einen Erwartungszähler für die (maximal mögliche) Lebenszeit an eine Gebrauchshistorie des Akkumulators anzupassen.

Als eine zweite Messeinrichtung kann mindestens eine Temperaturmesseinrichtung vorgesehen sein. Temperaturen sind von der Messeinrichtung wiederholt messbar und als eine Wertfolge abspeicherbar. Zwischen zwei Temperaturmessungen kann z. B. eine Anzahl von Stunden vergehen. Eine gute Näherung für die Berechnung der Lebenszeit wird dadurch erhalten, dass die Zeit zwischen zwei Temperaturmessungen für eine Gewichtung des Temperaturmesswerts herangezogen wird. Unter Hinzuziehung der Temperaturmessungen ist somit ein Batteriealterungsbeitrag berechenbar. Ein in einem Speicher vorgehaltener Batteriealterungswert wird durch den berechneten Beitrag erhöht. Die aktualisierte Batteriealterung kann in einem Speicher für nachfolgende Berechnungen abgelegt werden. Eine mithilfe einer ersten Messeinrichtung und eine mithilfe einer zweiten Messeinrichtung bestimmte Batteriealterung ist, insbesondere in einer alternativen Ausführungsform, auch getrennt in dem Speicher abspeicherbar, um die einzelnen Beiträge zu einem späteren Zeitpunkt analysieren zu können. Auf diese Weise lässt sich die Batteriealterung besonders gut nachverfolgen.

Eine Ausgabevorrichtung, die mindestens eine zweite Leuchtdiode oder sogar weitere Leuchtdioden umfasst, ermöglicht zum einen eine Redundanz in der optischen Datenübertragung. Eine zweite Leuchtdiode, neben einer ersten Leuchtdiode, kann aber auch dazu dienen, Lebenszahl durch verschiedene Stellen anzuzeigen, wie z. B. Dezimalstellen oder Binärstellen, wobei einer Zahlenstelle vorzugsweise jeweils mindestens eine Leuchtdiode zugeordnet ist. Die erste und die zweite Leuchtdiode können sich jeweils in einer abgestrahlten Lichtwellenlänge unterscheiden. Es können Leuchtdioden zur Anwendung kommen, die eine erste Lichtfarbe und eine zweite Lichtfarbe abstrahlen können. Vorteilhaft ist es, wenn eine der Lichtfarben eine Warnfarbe ist. Mithilfe einer Warnfarbe kann eine kritische Lebenszahl noch deutlicher hervorgehoben werden. Unterschiedliche Farben sind z. B. durch die einer Mehrfarbenleuchtdiode zugeführte Leuchtspannungen einstellbar.

Zur Berechnung einer Lebenszahl können verschiedene Berechnungsmethoden herangezogen werden. In einer ersten Art der Berechnung kann beispielsweise eine Summenwertberechnungsmethode gewählt werden. Eine zweite Methode einer geeigneten Berechnung ist eine Differenzwertberechnungsmethode. Bei einer Summenwertberechnung wird ein Ladezyklenwiderstand herangezogen, der durch eine berechnete Ladezyklenprognose erhöht wird. Als Lebenszahl ausgegeben, wird ein Erwartungswert für ein weiteres Leben des Akkumulators ermittelt. Bei einer Differenzwertberechnung wird eine Lebenszahl basierend auf einer Maximalladezyklenzahl ausgegeben. Die Maximalladezyklenzahl wird aus einem Ladezyklenwiderstand berechnet, wobei die Ladezyklenzahl ausgehend von einer prognostizierten Ladezyklenzahl ereignisabhängig verringert wird. In die Berechnung der prognostizierten Ladezyklenzahl geht mindestens eine Zustandsmessung ein. Die Lebenszahl kann somit in einer Ausgestaltung auf eine möglichst lange Ausdehnung des Akkumulatorlebens ausgestaltet sein oder in einer alternativen Ausgestaltung auf einen möglichst sicheren Akkumulatorenbetrieb ausgerichtet werden. Mischformen sind ebenfalls vorstellbar.

Der Zustandsindikator kann z. B. einen elektromagnetischen Empfänger aufweisen. Der Empfänger ermöglicht es, dass der Zustandsindikator besonders stromsparend arbeitet, indem ein Abfragesignal dazu hergenommen wird, die Ausgabevorrichtung zur Ausgabe oder zur Wiedergabe einer Lichtpulsfolge für die Lebenszeit anzusteuern. Ohne eine Aktivierung verbleibt die Ausgabevorrichtung still bzw. dunkel.

Zusätzlich zu einer Lebenszahl können weitere Informationen von dem Zustandsindikator ausgegeben werden. Hierfür ist es besonders vorteilhaft, wenn als Taktgeber ein Intervallpulsfrequenzgeber vorgesehen ist. Damit ist es möglich, Pulsfrequenzgruppen zu bilden, die sich jeweils durch eine Frequenz unterscheiden. Dadurch können z. B. Lebenszahlen von verschiedenen Akkumulatorzellen nacheinander übertragen werden. Eine Zuordnung einer Pulsfrequenz zu einem Akkumulator bzw. einer Akkumulatorzelle kann dadurch sicher erfolgen, dass ein Pulsfrequenzintervall für die Lebenszahl mit einer Identifikationspulsfolge verbunden wird. Auch ist es möglich, die Identifikationspulsfolge als eine Überstruktur einer Lebenszahlpulsfrequenz aufzuprägen, wobei die Verbindung aus Lebenszahl und Pulsfrequenz zur Ausbildung der Identifikationspulsfolge in vorgebbaren Zeitabständen für ein vorgebbares Zeitintervall ein- oder mehrmals unterbrochen werden.

Eine besonders genaue Überwachung eines Akkumulators ist durch eine Mehrzahl von Messvorrichtungen möglich. Jeder Akkumulatorzelle können eine oder mehrere Messvorrichtungen zugeordnet sein. Eine Akkumulatorzelle kann einen Zellenzustandssensor aufweisen, der für die vom Zellenzustandssensor überwachte Akkumulatorzelle aus einer Mehrzahl von Akkumulatorzellen z. B. einen elektrochemischen Zustand der Zelle für eine Messvorrichtung erfassbar macht. Für eine einzelne Akkumulatorzelle ist damit eine Zellenlebenszahl bestimmbar. Aus den ermittelten Zellenlebenszahlen kann eine Recheneinheit einen Extremwert bestimmen. Als ein Extremwert kommt z. B. ein frühestes, zu erwartendes Ausfallsdatum einer Akkumulatorzelle in Betracht, wenn auf eine besonders hohe Betriebssicherheit Wert gelegt wird. Nach einem weiteren Aspekt ist es möglich, aus den Zellenlebenszahlen einen Wahrscheinlichkeitswert zu berechnen, wonach von einer zukünftigen Zeit eines sicheren Betriebs ausgegangen werden kann. Damit lässt sich eine maximale Betriebszeit eines Akkumulators optimieren, z. B. wenn ein Ausfall einer vorher festgelegten Anzahl von Akkumulatorzellen in Kauf genommen werden kann, bis überhaupt von einem Lebenszeitende eines Akkumulators auszugehen ist.

Das Kommunikationssystem mit dem Zustandsindikator umfasst vorzugsweise ein tragbares Erfassungssystem. Das Erfassungssystem kann ein Funknetzgerät, wie ein Mobiltelefon, sein, welches ein Mikrophon als Tonaufnehmer und einen Lautsprecher als Tongeber aufweist. Mobiltelefone sind oftmals auch mit Kameras ausgestattet, mit denen eine Bildfolge aufzeichnenbar ist. Die Kameras bieten z. B. eine Auflösung von mehreren Megapixeln und können Bildfolgen von 30 Hz und mehr aufzeichnen, also wenigstens 30 Hz-Bildfolgen aufnehmen. Anders gesagt, es ist das Erfassungssystem mit der Ausgabevorrichtung des Zustandsindikators optisch oder akustisch verbindbar. Erfasste Daten, die von der Ausgabevorrichtung stammen, können in dem Erfassungssystem angezeigt werden. Insbesondere ist eine Lebenszahl, die z. B. in Reaktion auf ein Abfragesignal von dem Erfassungssystem an den Zustandsindikator erhalten wurde, auf einem Bildschirm, z. B. auf einem Display eines Mobiltelefons, darstellbar.

Von dem Erfassungssystem erfasste Bilder bzw. Bildfolgen können in einem Bildauswertungsmodul des Erfassungssystems analysiert werden. Mithilfe einer optischen Abbildungsvorrichtung des Erfassungssystems sind einzelne Leuchtdioden des Zustandsindikators auflösbar. In einer Bilderfolge kann für jede Leuchtdiode eine eigene Blinkfrequenz ermittelt werden. Damit ist es möglich, gleichzeitig mehrere Akkumulatorzellen im Hinblick auf deren Lebenszeit abzufragen. Eine Datenübertragungsverbindung zwischen einem Zustandsindikator und einem Erfassungssystem des Kommunikationssystems kann bidirektional noch verlässlicher arbeiten, wenn Transceivermodule jeweils eingebaut sind, die im Gigahertz-Bereich arbeiten. Die Transceivermodule sind jeweils aufeinander abgestimmt, sodass ein Datenaustausch zwischen den Komponenten des Kommunikationssystems schnell und sicher erfolgen kann.

Unter anderem ist es möglich, Daten von dem Empfangsgerät auf den Zustandsindikator, insbesondere die Recheneinheit des Zustandsindikators, zu übertragen, wenn die Recheneinheit einen geeigneten Funkempfänger aufweist. Beispielsweise können Rechenprogrammmodule auf die Recheneinheit übertragen werden und/oder Werte, wie Batteriekennwerte oder eine Kennwerthistorie. Auf diese Weise lässt sich der Zustandsindikator mit einfachen Mitteln an technische Weiterentwicklungen anpassen.

In einer günstigen Ausgestaltung des Kommunikationssystems ist dieses in eine Zentralstation einbindbar. Die Zentralstation kann einen Zentralspeicher aufweisen, in dem eine Datenbank vorgehalten wird. Ein Funknetzgerät als Empfangsstation kann aus der Datenbank Batteriekennwerte beziehen, wenn diese z. B. in dem Zustandsindikator nicht vorhanden sind. Das Funknetzgerät kann also als eine Art Relaisstation zwischen einer Zentralstation und einem Zustandsindikator dienen. Die von dem Zustandsindikator in dem Funknetzgerät empfangenen Daten bzw. Lebenszahlen können in dem Funknetzgerät zwischengespeichert und in eine Recheneinheit des Funknetzgeräts aufbereitet werden. Daten des Zustandsindikators sind durch das Funknetzgerät an die Zentralstation, insbesondere in die Daten der Zentralstation, übertragbar. Diese Archivierungsfunktion ermöglicht es, Daten auch nach längeren Zeiträumen zu sichten, um z. B. nach früher sich abzeichnenden Fehlern zu suchen. Anders gesagt, bietet ein Kommunikationssystem vielfältige Möglichkeiten, um Daten, die von einem Zustandsindikator beziehbar sind, sowohl zur Überwachung der Akkumulatoren als auch als Entscheidungsgrundlage für weitere Analysen oder Handlungsanweisungen auszuwerten.

Die zuvor dargestellten Kombinationen und Ausführungsbeispiele lassen sich auch in zahlreichen weiteren Verbindungen und Kombinationen betrachten.

Besonders vorteilhafte, weitere Aspekte lassen sich auch wie folgt darstellen:

Die Ausgabevorrichtung des Zustandsindikators hat in einer Ausgestaltung mindestens eine zweite Leuchtdiode. Dann ist es insbesondere möglich, die mindestens eine erste Leuchtdiode einen ersten Teil, wie eine erste Dezimalstelle, einer Lebenszahl und die mindestens eine zweite Leuchtdiode mindestens einen weiteren Teil, wie eine weitere Dezimalstelle, der Lebenszahl anzeigen zu lassen. Die Leuchtdioden sind Anzeigeelemente für einzelne Komponente der Lebenszahl. Vorzugsweise strahlen die Leuchtdioden Licht unterschiedlicher Wellenlängen ab.

Der Zustandsindikator kann einen elektromagnetischen Empfänger aufweisen, wobei die Ausgabevorrichtung durch einen Empfang eines elektromagnetischen Abfragesignals aktivierbar ist. Als elektromagnetisches Abfragesignal kommt eine Abfragelichtpulsfolge infrage. Durch ein Abfragesignal kann eine Ausgabe oder eine Wiedergabe aktiviert werden. Die Ausgabe und/oder die Wiedergabe ist aktivierbar.

Der Pulsfrequenzgenerator kann z. B. ein Intervallpulsfrequenzgeber sein, wobei durch den Intervallpulsfrequenzgeber in einem Pulsfrequenzintervall eine elektronische Frequenz, die der Lebenszahl zugeordnet ist, in einer zeitlichen Abfolge mit einer Identifikationspulsfolge von der Ausgabevorrichtung ausgebbar ist.

Das alles kann bzw. die einzelnen Ausführungsbeispiele können mit einer Zentralstation zusammenwirken. Die Zentralstation kann eine Datenbank für Batteriekennwerte aufweisen bzw. beinhalten. Insbesondere mittels des zuvor beschriebenen Funknetzgeräts kann eine Datenübertragungsverbindung zu der Datenbank herstellbar sein. Sobald eine Datenübertragungsverbindung eingerichtet ist, können Daten übertragen werden, wie z. B. die Lebenszahl. Die Daten können in der Datenbank abspeicherbar sein. In einer Weiterbildung ist mindestens ein Batteriekennwert auf einem Datenspeicher des Funknetzgeräts abspeicherbar.

### Figurenkurzbeschreibung

Die vorliegende Erfindung kann noch besser verstanden werden, wenn Bezug auf die beiliegenden Figuren genommen wird, die beispielhaft besonders vorteilhafte Ausgestaltungsmöglichkeiten darlegen, ohne die vorliegende Erfindung auf diese einzuschränken, wobei
Figur 1 einen Zustandsindikator mit einem Array von Energiespeicherpaketen, einen Empfänger und eine Ladungselektronik als Teil einer Energieversorgungseinrichtung zeigt,
Figur 2 eine Ausführungsform eines Zustandsindikators ähnlich der in Figur 1 gezeigten Ausführungsform, darüber hinaus aber mit nachrüstbaren Baugruppen von zusätzlichen Sender- und Empfängermodulen sowie ein Erfassungssystem und eine Zentralstation zeigt,
Figur 3 eine mögliche Übertragung einer Lebenszeit zeigt,
Figur 4 eine weitere, mögliche Übertragung von Lebenszeiten zeigt und
Figur 5 eine schematische Konfiguration eines Kommunikationssystems zeigt.

### Figurenbeschreibung

Die in den einzelnen Figuren gezeigten Ausgestaltungsmöglichkeiten lassen sich auch untereinander in beliebiger Form verbinden.

Figur 1 zeigt eine Energieversorgungseinrichtung 102, die mit einem Zustandsindikator 101 ausgestattet ist. Die Energieversorgungseinrichtung 102 dient der Versorgung eines Verbrauchers mit elektrischem Strom über die Verbraucheranschlüsse 195.

Zudem zeigt Figur 1 ein Array von Akkumulatoren 103, 103', 103", 103"', 103^{IV}, 103^{V}, die auch als Energiespeicherpakete bezeichnet werden können. Eine Ladeelektronik 194 ist als Teil der Energieversorgungseinrichtung 102 vorhanden. Die Akkumulatoren 103, 103', 103", 103"', 103^{IV}, 103^{V} sind jeweils mit einer Spannungsmesseinrichtung 107, 107', 107", 107"", 107^{IV}, 107^{V} und mit einer Temperaturmesseinrichtung 108, 108', 108", 108"', 108^{IV}, 108^{V} verbunden, die auf die Akkumulatoren 103, 103', 103", 103"', 103^{IV}, 103^{V} zur Bildung des Zustandsindikators 101 aufsetzbar sind. Es werden somit Anschlüsse unter Nutzung der Akkumulatorpole 111, 111', 111", 111'", 111^{IV}, 111^{V} hergestellt. Der Zustandsindikator 101 umfasst eine Recheneinheit 104, die über eine Graetz-Schaltung 113 von den Akkumulatoren 103, 103', 103", 103'", 103^{IV}, 103^{V} mit Strom versorgt wird. Dank der Graetz-Schaltung 113 ist die Recheneinheit 104 verpolungssicher bzw. verpolungstolerant an den Akkumulatoren 103, 103', 103", 103"', 103^{IV}, 103^{V} betreibbar. Damit kann der Zustandsindikators 101 an die Energieversorgungseinrichtung 102 angebracht werden, ohne dass es einer vorbereitenden Potentialmessung der Energieversorgungseinrichtung 102 bedarf. An die Graetz-Schaltung 113 ist eine Spannungsherabsetzungsschaltung (ohne Bezugszeichen) angeschlossen. Aus der Spannungsherabsetzungsschaltung wird die Recheneinheit 104 versorgt. Ferritringe 140, 140^{I}, 140", 140^{III}, 140^{IV}, 140^{V}, die im Bereiche der Akkumulatorpole 111, 111', 111", 111"', 111^{IV}, 111^{V} der Plusanschlüsse platziert sind, dienen der Unterdrückung von Störungen bei der Messwerterfassung. Die Messeinrichtungen 107, 107', 107", 107"', 107^{IV}, 107^{V}, 108, 108', 108", 108"', 108^{IV}, 108^{V} sind mit der Recheneinheit 104 verbunden, die eine Auswerteeinheit 119 zur Aufbereitung von Messdaten umfasst. Die Recheneinheit 104 weist ein Rechenprogramm auf, das aus Daten, die von der Auswerteeinheit 119 bereitgestellt werden, eine Lebenszeit errechnet. Der Wert für die (prognostizierte bzw. noch bevorstehende) Lebenszeit wird von einem Pulsfrequenzgenerator 117 in eine Spannungspulsfolge gewandelt. Die Spannungspulsfolge wird der Leuchtdiode 128 zugeleitet, die entsprechend der Spannungspulsfolge, insbesondere mit einer Blinkfrequenz, Licht abstrahlt. Wird ein anderes Programm auf der Recheneinheit 104 aktiviert, kann eine zweite Leuchtdiode 129 von der Recheneinheit 104 zum Blinken gebracht werden. Die zweite Leuchtdiode 129 dient zur Anzeige der schon überdauerten Lebenszeit. Damit kann unter anderem sichergestellt werden, dass auch bei einer defekten Leuchtdiode 128, 129 noch ein Wert für eine Anzeige einer Lebenszeit durch den Zustandsindikator 101 ausgebbar ist.

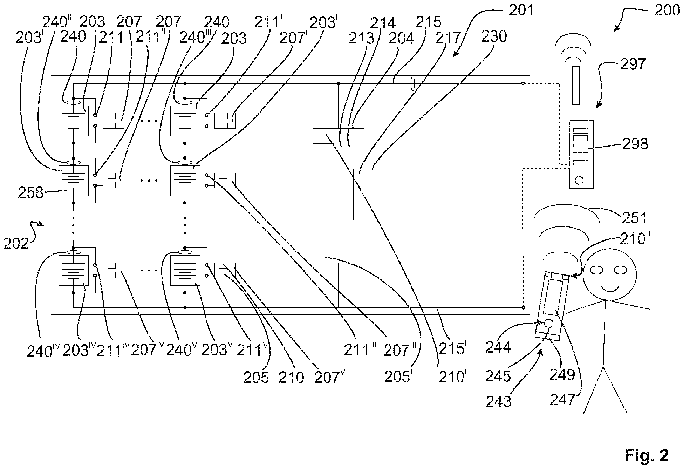

Figur 2 zeigt eine weitere Ausführungsform eines Zustandsindikators 201, der in vielen Punkten dem Zustandsindikator 101 aus Figur 1 ähnelt. Daher sei zur Vereinfachung der Diskussion der Figur 2 auf die Ausführungen zu Figur 1 hingewiesen, die an vielen Stellen sinngemäß auch auf die Figur 2 zu übertragen sind.

Der Zustandsindikator 201 in Figur 2 ist mit der Energieversorgungseinrichtung 202 verbunden. Der Zustandsindikator 201 und das Funknetzgerät 243 bilden zusammen ein Kommunikationssystem 200. Das Funknetzgerät 243 kann auch mit einer Zentralstation 297 eine Kommunikation aufbauen, wodurch das Kommunikationssystem 200 erweitert wird. Dadurch kann das Funknetzgerät 243 die Datenbank 298 der Zentralstation 297 nutzen.

In Figur 2 sind mehrere Energiespeicherpakete, wie die Akkumulatoren 203, 203', 203", 203"', 203^{IV}, 203^{V}, enthalten. Die Energiespeicherpakete 203, 203", 203^{IV} sind miteinander seriell verschaltet. Dazu parallel verschaltet sind die untereinander seriell angeordneten Energiespeicherpakete 203', 203"', 203^{V}. Mit anderen Worten, bilden die Energiespeicherpakete 203, 203" und 203^{IV} sowie die Energiespeicherpakete 203', 203'" und 203^{V} jeweils eine in Serie elektrisch verbundene Gruppe von Energiequellen, wobei die Gruppen zueinander in elektrisch parallel verschalteter Anordnung stehen. Die Energiespeicherpakete 203, 203', 203", 203"', 203^{IV}, 203^{V} bilden zusammen ein unterbrechungsfreies Stromversorgungssystem 202. Durch eine Verbindung zu den Polen von jedem der Energiespeicherpakete 203, 203', 203", 203'", 203^{IV}, 203^{V} wird die Spannung jeweils über ein Anschlusspaar, das jeweils einen Anschluss 211, 211', 211", 211'", 211^{IV}, 211^{V} umfasst, der an einem Eingang von zugeordnete Messeeinrichtung 207, 207', 207", 207"', 207^{IV}, 207^{V} zu finden ist, abgegriffen. Durch die unmittelbare Brückung zwischen Pol und Anschluss 211, 211', 211", 211'", 2111^{IV}, 211^{V} kann - vereinfacht - von der Polspannung an dem Messeingang der jeweiligen Messeinrichtung 207, 207', 207", 207"', 207^{IV}, 207^{V} ausgegangen werden. Die Spannung wird an eine dem jeweiligen Energiespeicherpaket 203, 203', 203", 203"', 203^{IV}, 203^{V} zugeordnete Messeeinrichtung 207, 207', 207", 207"', 207^{IV}, 207^{V}, die auch als Messelektronik bezeichnet werden kann, übertragen. Jedes Energiespeicherpaket 203, 203', 203", 203"', 203^{IV}, 203^{V} ist mit seiner eigenen, in Figur 2 nur symbolisch dargestellten, Messelektronik 207, 207', 207", 207"', 207^{IV}, 207^{V} ausgestattet. Unter anderem sind die jeweilige Polspannung und über einen Temperatursensor (nicht dargestellt) eine Temperatur (siehe z. B. Temperaturmesseinrichtung 108 in Figur 1) jedes einzelnen Energiespeicherpakets 203, 203', 203", 203'", 203^{IV}, 203^{V} detektierbar.

An dem (Plus-)Pol jedes Energieversorgungspakets 203, 203', 203", 203"', 203^{IV}, 203^{V} befindet sich ein Ferritring 240, 240', 240", 240"', 240^{IV}, 240^{V}, wobei ein Leitungsanschluss (ohne Bezugszeichen) zu dem Pol durch den Ferritring 240, 240', 240", 240"', 240^{IV}, 240^{V} führt. Die Ferritringe 240, 240', 240", 240"', 240^{IV}, 240^{V} nutzen ihre Induktivitäten, damit sie jeweils wie ein Tiefpassfilter wirken können. Die Impedanz des Stromkreises mit einem Ferritring 240, 240', 240", 240"', 240^{IV}, 240^{V} steigt mindestens linear mit der Frequenz eines Wechselstromsignals an. Ein Gleichstrom, der von einem Energiespeicherpaket 203, 203', 203", 203"', 203^{IV}, 203^{V} stammt, kann den Ferritring 240, 240', 240", 240"', 240^{IV}, 240^{V}, ohne einen zusätzlichen Widerstand vorzufinden, passieren.

In der vorliegenden Ausführungsform, in der eine Leitung 215, 215' zur Übertragung eines Wechselspannungssignals genutzt wird, das z. B. von der Messelektronik 207, 207', 207", 207"', 207^{IV}, 207^{V} auf eine Leitung 215, 215' aufgeprägt wird, kann das Wechselspannungssignal durch den Ferritring 240, 240', 240", 240"', 240^{IV}, 240^{V} abgeschwächt werden. Eine Signalstärke des Wechselspannungssignals, die z. B. anhand der Amplitude des Signals bestimmbar ist, reicht zur Signalübertragung aus. Das Wechselspannungssignal wird bei einem Stromfluss in Richtung auf ein Inneres 258 des Energieversorgungspakets bzw. Energiespeicherpakets 203" durch die zusätzliche Impedanz abgeschwächt. Störsignale mit einer höheren Frequenz als das Signal von der Messelektronik 207, 207', 207", 207"', 207^{IV}, 207^{V} werden von den Ferritringen 240, 240', 240", 240"', 240^{IV}, 240^{V} unterdrückt. Ein weiterer Ferritring (ohne Bezugszeichen) filtert vor einem speziell durch die Energiespeicherpakete 203, 203', 203", 203"', 203^{IV}, 203^{V} elektrisch versorgten Bereich auch die Signale heraus, die an die Recheneinheit 204 gesendet werden, damit diese nicht zu den Verbrauchern gelangen.

Die Ferritringe 240, 240', 240", 240"', 240^{IV}, 240^{V} in Figur 2 filtern Hochfrequenzsignale aus, also beispielsweise Signale oberhalb einer Frequenz von 500 MHz. Die Ferritringe 240, 240', 240", 240"', 240^{IV}, 240^{V} trennen Energieleitungen 215, 215' hochfrequenzmäßig von den Energiespeicherpaketen 203, 203', 203", 203"', 203^{IV}, 203^{V}. Besonders vorteilhaft sind Filter, bei denen eine Funktion der Impedanz in Abhängigkeit von der Frequenz - in einer mathematischen Darstellung - eine Polstelle aufweist, also eine Stelle, an der die Funktion divergiert. Eine Messelektronik, wie die Messelektronik 207^{V}, umfasst als Komponente einen Sender, den Sender 210, und einen Empfänger, vorzugsweise den Empfänger 205. Sender 210 und Empfänger 205 liegen als ein Transceivermodul 210, 205 vor, das mit einem mehrkanaligen Transceivermodul 205', 210' der Recheneinheit 204, z. B. unter Verwendung von Bluetooth-Technologie (also eine Technologie, die einen bekannten Funkstandard nutzt) kommunizieren kann.

Ein Kanal ist beispielsweise einer Gruppe von Energiespeicherpaketen, wie den Energiespeicherpaketen 203, 203', 203", 203"', 203^{IV}, 203^{V}, zugeordnet. Die Recheneinheit 204 kann mehrere Gruppen überwachen. Die Recheneinheit 204 empfängt und dekodiert Signale, die jeweils von den Messelektroniken 207, 207', 207", 207'", 207^{IV}, 207^{V} stammend, übertragen werden. Die Recheneinheit 204 ordnet die Signale eindeutig den jeweiligen Energiespeicherpaketen 203, 203', 203", 203"', 203^{IV}, 203^{V} zu. Insbesondere können Ladesteuersignale oder Schaltsignalen von dem Sender 210' zu dem Empfänger 205 übertragen werden. Der Sender 210' ist Teil der Recheneinheit 204. Die Signalübertragung, insbesondere von Messsignalen, erfolgt von dem Sender 210 zu dem Empfänger 205'. Der Sender 210 ist Teil der Messelektronik 207^{V}.

Damit können auch schwer zugängliche Akkumulatoren 203, 203', 203", 203"', 203^{IV}, 203^{V} mit einem Zustandsindikator 201 überwacht werden.

Die Recheneinheit 204 ist mit einer Graetz-Schaltung 213 ausgestaltet, und somit unempfindlich gegen eine Verwechselung einer Polung beim Einbau des Zustandsindikators 201. Die Recheneinheit 204 umfasst einen Mikrocontroller 214. Der Mikrocontroller 214 weist einen Taktgeber 217 auf, durch den verschiedene Pulsfrequenzen generierbar sind. Der Taktgeber 217 ist als Intervallpulsfrequenzgeber - nach Bedarf - durch eine Programmierung der Recheneinheit 204 ansteuerbar. Eine OLED-Anzeige 230 dient als Ausgabevorrichtung. OLED steht für "organic light emitting diode", also ein Dünnschichtbauelement aus organischen halbleitenden Materialien, von denen Licht abstrahlbar ist. An Stelle der OLED kann, quasi als eine Alternative oder ergänzend, auch ein LC-Display verwendet werden. Das LC-Display ist eine Anzeige, bei der ein Kontrast durch Ausrichtung von Flüssigkristallen erzeugt wird. Die OLED-Anzeige 230 kann zumindest auf einem Bereich der Anzeige 230 eine von der Recheneinheit 204 berechnete Lebenszeit als eine Blinkfrequenz optisch ausgeben. Ein Identifikationssignal bzw. eine Adresse, über die ein Akkumulatoren 203, 203', 203", 203"', 203^{IV}, 203^{V} eindeutig bestimmt ist, ist durch einen Strichcode auf der OLED-Anzeige 230 anzeigbar. Damit kann für jeden Akkumulator 203, 203', 203", 203'", 203^{IV}, 203^{V} eine Lebenszeit ausgegeben werden.

Eine für die Überwachung der Energieversorgungseinrichtung 202 zuständige Person (ohne Bezugszeichen) kann die OLED-Anzeige 230 mit einem Mobiltelefon 243 lesen, das ein optisches Erfassungssystem 244 aufweist. Über einen Lichtsensor 245 des optischen Erfassungssystems 244 wird insbesondere eine Blinkfrequenz der OLED-Anzeige 230 erfasst. Das Mobiltelefon 243 ist mit einer eigenen, zweiten Energieversorgungseinrichtung 249 ausgestattet. Damit kann sich die Person bei der Überwachung frei bewegen. Das Mobiltelefon 243 ist mit einem zweiten Transceivermodul 210" ausgestattet, das eine weitere, optionale Ausführungsform als Teil eines Mobiltelefons wie dem Mobiltelefon 243 darstellt. Daten können von dem Mobiltelefon 243 an die Recheneinheit 204 übersendet werden. Durch Funkdatenübertragung 251 kann das Mobiltelefon 243 auch Daten aus der Zentralstation 297 abrufen bzw. in der Datenbank 298 ablegen. Damit kann simultan mit der Überwachung auch eine Datensicherung erfolgen. Der von dem Zustandsindikator 201 bereitgestellte und durch das Mobiltelefon 243 empfangene Wert für die Lebenszeit ist auf einem berührungsempfindlichen Bildschirm 247, der als Anzeige dient, darstellbar. Damit kann die Person Werte für die Lebenszeit tabellarisch erfassen sowie erfasste Werte der Lebenszeiten grafisch darstellen.

An die Recheneinheit 204 schließt sich den elektrischen Leitungen 215, 215' weiter folgend ein Bereich an, der von der Energieversorgungseinrichtung 202 mit elektrischer Energie versorgt wird (strichliierte Leitungen). In diesem Bereich befindet sich auch einer der Verbraucher, nämlich die Zentralstation 297, die die elektrische Energie aus den Energiespeicherpaketen 203, 203', 203", 203"', 203^{IV}, 203^{V} benutzen kann. Beispielsweise bei einem Lebenszeitende kann unmittelbar von dem Mobiltelefon 243 aus ein Auftrag für eine Wartung der Energieversorgungseinrichtung 202 verschickt werden, um eine Gefahr eines Ausfalls der Energieversorgungseinrichtung 202 so gering wie möglich zu halten.

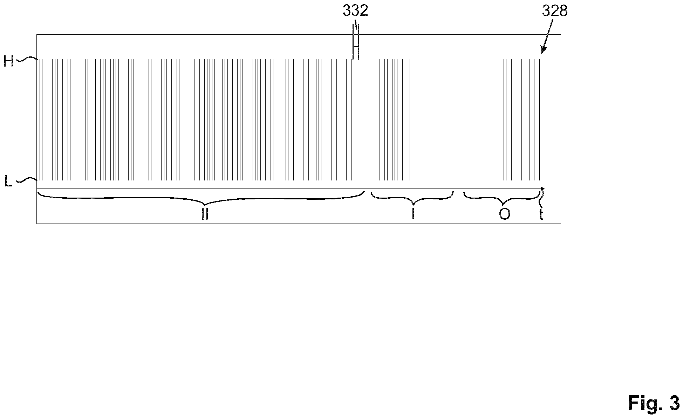

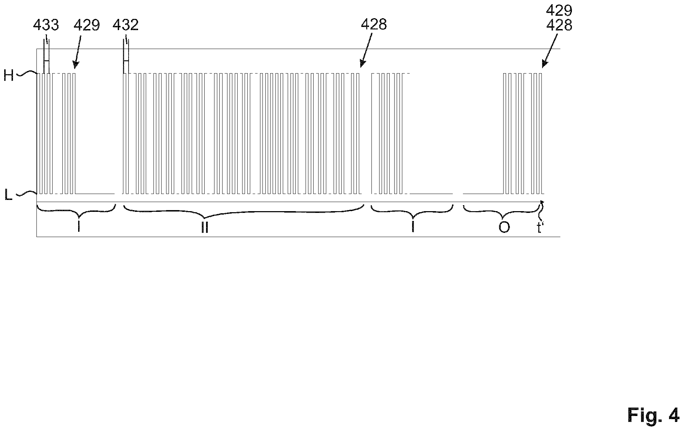

Figur 3 sowie Figur 4 zeigen die Übertragung von Informationen durch Leuchtdioden, und die Figuren werden daher im Folgenden gemeinsam diskutiert.

In Figur 3 wird Information durch Licht einer ersten Leuchtdiode 328 abgestrahlt. Wie sich aus der Signalfolge unter zeitlichem Aspekt ergibt, deren zeitlicher Verlauf gegenüber der t-Achse t zu entnehmen ist, können einzelne Bits wie "I" oder "O" mit einer Trägerfrequenz, wie im vorliegenden Fall 140 kHz, übertragen werden. Die Lichtintensität pendelt zwischen einem höheren Intensitätswert H, einem Hellwert, und einem niedrigeren Intensitätswert L, der auch als Dunkelwert bezeichnet werden kann. Durch Intervallbildung wird eine Identifikationspulsfolge I, 0 bereitgestellt. Die Übertragung der Lebenszeit erfolgt durch eine Blinkfrequenz 332 der Leuchtdiode 328 in der Phase II. Der Intensitätswert H folgt einer entsprechenden Versorgung der Leuchtdiode 328 mit Strom. Es ist auch möglich, zur Informationsübertragung einen Manchester-Code zu verwenden.

Figur 4 zeigt die Übertragung von Informationen durch blinkende Leuchtdioden 428, 429. Wie aus der Signalfolge in der zeitlichen Entwicklung auf der t-Achse zu entnehmen ist, werden einzelne Bits wie "I" oder "O" mit einer Trägerfrequenz übertragen, die im vorliegenden Fall 140 kHz beträgt und von einer ersten Leuchtdiode 428 und einer zweiten Leuchtdiode 429 synchron als Lichtpulse abgestrahlt werden. Einzelne Bits wie "I" oder "O" können als Identifikationspulsfolge 0, I für einen Zustandsindikator, wie der Zustandsindikatoren 101 in Figur 1 oder der Zustandsindikator 201 in Figur 2, miteinander kombiniert werden. Die Lichtintensität oszilliert zwischen einer höheren Strahlungsstärke H und einer niedrigeren Strahlungsstärke L. Die Übertragung der Information erfolgt mit Unterbrechungen. Es kann auch gesagt werden, dass die Lichtintensität als Amplitudenmodulation einer Lichthelligkeit die Lebenszeit enthält. Aus Figur 4 lässt sich entnehmen, dass der Identifikationspulsfolge 0, I eine erste Lebenszeitübertragung II durch die erste Leuchtdiode 428 mit einer ersten Blinkfrequenz 432 folgt. In einer Phase, die vor, genauso gut aber auch nach einer Fortsetzungspulsfolge I liegt, kann durch die zweite Leuchtdiode 429 dann eine zweite Lebenszeitübertragung II durch eine zweite Leuchtdiode 429 mit einer zweiten Blinkfrequenz, die der Blinkfrequenz 433 der Leuchtdiode 429 entspricht, erfolgen, die einem zweiten Akkumulator, wie den Akkumulatoren 103, 103', 103", 103"', 103^{IV}, 103^{V} in Figur 1 oder den Akkumulatoren 203, 203', 203", 203"', 203^{IV}, 203^{V} in Figur 2 bzw. einer zweiten Akkumulatorzelle zugeordnet ist. Die Blinkfrequenzen 432, 433 ergeben sich durch Betrachtung der zeitlichen Abläufe gegenüber der Zeit t'.

Bei einer Nutzung einer Manchester-Codierung werden Informationen auf redundante Weise übertragen. Einem Intensitätswert H bzw. L muss der entgegengesetzte Intensitätswert L bzw. H folgen. Das Bit "I" wird z. B. durch eine Stromwertfolge bzw. Spannungswertfolge H, gefolgt von L dargestellt. Beim Bit "O" sind die Phasen mit einer wechselnden Übertragung Werte L, H genau umgekehrt gereiht als beim Bit "I". Ein Beginn einer Informationsübertragung kann einer Überwachungselektronik durch eine Phase II, die selbst keine Information enthält, signalisiert werden.

Eine Manchester-Codierung kann auch zum leitungsgebundenen Senden von Informationen durch Messelektroniken, insbesondere zwei Messelektroniken wie die Messelektroniken 107", 107'" (vgl. Figur 1) gleichzeitig, erfolgen. Hierbei werden deren H und L durch Spannungen, insbesondere aufaddiert, übertragen. Die Spannungen können in gesonderten Ausführungsformen auch auf eine Trägerfrequenz, wie eine Wechselspannungsfrequenz, aufaddiert werden. Die Überwachungselektronik kann z. B. mit der Recheneinheit 104 (gezeigt in Figur 1) verbunden sein.

Bei mehreren Messelektroniken wird von der Überwachungselektronik übertragene Information als ungültig verworfen, wenn beispielsweise dem Spannungswert H nicht der Spannungswert L folgt. Durch redundante Informationsübertragung kann, insbesondere durch die Überwachungselektronik 104 (vgl. Figur 1) oder das Funknetzgerät 243 (aus Figur 2), die erhaltene Information auf Plausibilität überprüft werden. Wie in Figur 4 gezeigt ist, kann eine Fortsetzung einer Datenübertragung vor einer weiteren Phase II ein sogenanntes Kontrollbit "I" bilden, mit welchem einem Empfänger, z. B. der Recheneinheit 104 aus Figur 1 oder den Transceivermodulen 205, 205' bzw. dem Funknetzgerät 243 aus Figur 2, im Falle eines Wertes "I" ein weiteres Informationspaket angekündigt werden kann.

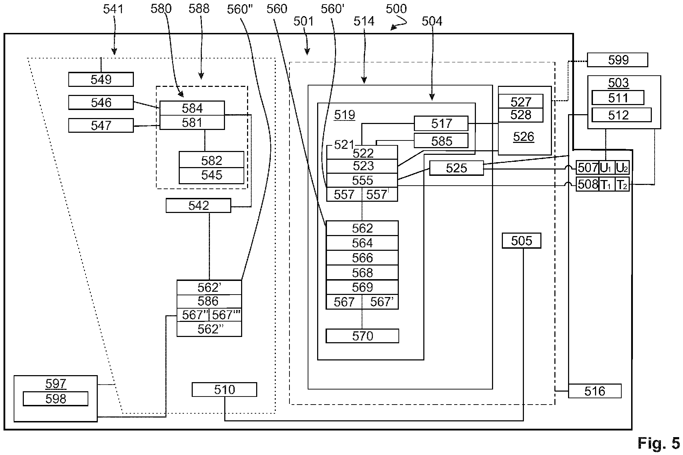

Figur 5 zeigt ein Kommunikationssystem 500, das einen Zustandsindikator 501 und ein Erfassungssystem 541 umfasst. Der Zustandsindikator 501 weist einen Mikrocontroller 514 auf, in dem eine Recheneinheit 504 enthalten ist. In der Recheneinheit 504 ist eine Auswerteeinheit 519 programmtechnisch realisiert. Es wird ein mehrstufiges Rechenprogramm 521 verwendet, das u. a. ein Zustandsberechnungsalgorithmus 522 und einen Ladezyklenberechnungsalgorithmus 523 aufweist. Der Auswerteeinheit 519 werden über einen Analogdigitalkonverter 525 Spannungsmessdaten U₁, U₂ von außen zugeführt, die von einer ersten Messeinrichtung 507 stammen. Der Auswerteeinheit 519 werden von außen Temperaturmesswerte T₁, T₂ zugeführt, die von einer zweiten Messeinrichtung 508 stammen. Weiterhin gehört zu der Auswerteeinheit 519 ein Lebenszähler 570, wodurch der Auswerteeinheit 519 eine aktuelle Zykluszahl 557 vorliegt. Eine verbleibende oder Rest-Zykluszahl 557^{I} ist ebenfalls in der Auswerteeinheit 519 vorhanden. Die aktuelle Zykluszahl 557 und die verbleibende Zykluszahl 557^{I} können miteinander abgeglichen, z. B. addiert werden.

Die errechnete Gesamtzykluszahl, in die die aktuelle Zykluszahl 557 und die verbleibende Zykluszahl 557^{I} eingehen, wird in der Auswerteeinheit 519 in dem Ladezyklenberechnungsalgorithmus 523 auf Plausibilität mit einer Lebenszahl 564 oder einer Zellenlebenszahl 567, 567^{I} geprüft. Mithilfe der ersten Messeinrichtung 507 kennt die Analyseeinrichtung auch die Entladetiefe 555 des überwachten Akkumulators 503. Die Messeinrichtungen 507, 508 sind mit dem Akkumulator 503 verbunden, der mindestens eine Akkumulatorzelle 512 und ein Akkumulatorpol 511 aufweist. Die Auswerteeinheit 519 hat Zugriff auf den Speicher 560. Das Rechenprogramm 521 operiert mit seinem eigenen Speicher 560'. In dem Speicher 560 wird ein Batteriekennwert 562, die Lebenszahl 564, ein fester Wert 566, eine Entladetiefensumme 568, eine Ladezyklenzahl 569 sowie die Zellenlebenszahlen 567, 567' vorgehalten. Die Auswerteeinheit 519 kann mithilfe des Rechenprogramms 521 somit eine aktualisierte Lebenszahl 564 bestimmen. Die Bestimmung der Lebenszahl 564 erfolgt nach einem Zeitplan 585. In dem Zustandsindikator 501 hat die Auswerteeinheit 519 in Verbindung mit der Recheneinheit 504 auch eine Verbindung zum Taktgeber 517, mit dem die Ausgabevorrichtung 526 betreibbar ist. Die Ausgabevorrichtung 526 weist einen Tongeber 527 und eine erste Leuchtdiode 528 auf. Damit ist eine Lebenszahl 564 sowohl akustisch als auch optisch z. B. über jeweilige, d. h. eigene, Frequenzen ausgebbar. Die Auswerteeinheit 519 kann über ein Transceivermodul 505 des Zustandsindikators 501 und ein Transceivermodul 510 des Erfassungssystems 541 einzelne Teile des Speichers 560 bzw. der Auswerteeinheit 519 aktualisieren. Mithilfe der Spannungsherabsetzungsschaltung 516 ist der Zustandsindikator 501 aus dem Akkumulator 503 mit Strom versorgbar. Der Analogdigitalkonverter 525 ermöglicht zusätzlich der Auswerteeinheit 519 eine Überwachung, ob eine korrekte Betriebsspannung bereitgestellt ist, um das einwandfreie Funktionieren des Zustandsindikators 501 sicherzustellen.

Die Ausgabevorrichtung 526 ist zumindest entweder akustisch oder optisch, idealerweise optisch und akustisch frei zugänglich platziert, damit Signale des Tongebers 527 oder der Leuchtdiode 528 an entfernte Empfänger 599 übertragbar sind. Ein Empfänger 599 wie ein Handy kann die Signale der Ausgabevorrichtung 526 aufnehmen.

Das Erfassungssystem 541 umfasst eine Recheneinheit 580 mit einem Bilderauswertemodul 581. Mithilfe einer optischen Abbildungsvorrichtung 588 werden über einen Lichtsensor 545 aufgezeichnete Bilderfolgen 582 in der Recheneinheit 580 ausgewertet. Das Erfassungssystem 541 hat eine eigene, zweite Energieversorgungseinrichtung 549, die unabhängig von dem Akkumulator 503 ist. Die Recheneinheit 580 kann Informationen von weiteren Sensoren wie dem Sensor 546, der ein Akustiksensor ist, auswerten. Zu der Recheneinheit 580 gehört das Sensorauswertemodul 584. Mithilfe des Sensorauswertemoduls 584 können Signale und damit Daten des Sensors 546 (und weiterer Sensoren) erfasst und ausgewertet werden. Auswerteergebnisse werden auf einer Anzeige optisch sichtbar gemacht. Das Erfassungssystem 541 weist einen Speicher 560" auf. In dem Speicher 560" werden ein Batteriekennwert 562', ein Berechnungsalgorithmus 586, Lebenszahlen 567", 567'" und ggf. weitere Batteriekennwerte wie der weitere Batteriekennwert 562" vorgehalten. Mithilfe einer Sendeeinrichtung 542 sind Daten aus dem Speicher 560" an eine Zentralstation 597 per Funk übertragbar und können dort in einer Datenbank 598 gesichert werden.

Über eine Anzeige 547 wie einem berührungsempfindlichen Bildschirm können die Auswerteergebnisse der Recheneinheit 580 an einen Benutzer wie einem Überwachungstechniker ausgegeben werden.

Mithilfe des Kommunikationssystems 500 kann z. B. ein Überwachungstechniker in kurze Zeit eine große Anzahl von Akkumulatoren, wie den Akkumulator 503, die jeweils mit einem Zustandsindikator, wie dem Zustandsindikator 501, ausgestattet sind, überprüfen.

**Bezugszeichenliste**

| | |
|---|---|
| 200, 500 | Kommunikationssystem |
| 101, 201, 501 | Zustandsindikator |
| 102, 202 | erste Energieversorgungseinrichtung, insbesondere Stromversorgungssystem |
| 103, 103', 103", 103"', 103^{IV}, 103^{V}, 203, 203', 203", 203"', 203^{IV}, 203^{V}, 503 | Akkumulator, insbesondere Bleiakkumulator |
| 104, 204, 504 | Recheneinheit |
| 205, 205', 505 | Transceivermodul, insbesondere Empfänger |
| 107, 107', 107", 107"", 107^{IV}, 107^{V}, 207, 207', 207", 207"', 207^{IV}, 207^{V}, 507 | erste Messeinrichtung, insbesondere Spannungsmesseinrichtung |
| 108, 108', 108", 108"', 108^{IV}, 108^{V}, 508 | zweite Messeinrichtung, insbesondere Temperaturmesseinrichtung |
| 210, 210', 210", 510 | Transceivermodul, insbesondere Sender |
| 111, 111', 111", 111"', 111^{IV}, 111^{V}, 211, 211', 211", 211'", 211^{IV}, 211^{V}, 511 | Anschluss, insbesondere Akkumulatorpol |
| 512 | Akkumulatorzelle |
| 113, 213 | Graetz-Schaltung |
| 214, 514 | Mikrocontroller |
| 215, 215' | Leitungen, insbesondere Energieleitungen |
| 516 | Spannungsherabsetzungsschaltung |
| 117, 217, 517 | Taktgeber, insbesondere Pulsfrequenzgenerator |
| 119, 519 | Auswerteeinheit |
| 521 | Rechenprogramm, insbesondere mehrschrittiges |
| 522 | Zustandsberechnungsalgorithmus |
| 523 | Ladezyklenberechnungsalgorithmus |
| 525 | Analogdigitalkonverter |
| 526 | Ausgabevorrichtung, insbesondere optische Ausgabevorrichtung |
| 527 | Tongeber |
| 128, 328, 428, 528 | Leuchtdiode, insbesondere erste Leuchtdiode |
| 129, 429 | zweite Leuchtdiode |
| 230 | Anzeige, insbesondere OLED-Anzeige oder LC-Display |
| 332, 432 | erste Blinkfrequenz insbesondere einer ersten Leuchtdiode |
| 433 | zweite Blinkfrequenz, insbesondere einer zweiten Leuchtdiode |
| 140, 140^{I}, 140^{II}, 140^{III}, 140^{IV}, 140^{V}, 240, 240', 240", 240"', 240^{IV}, 240^{V} | Ferritring |
| 541 | Erfassungssystem |
| 542 | Sendeeinrichtung |
| 243 | Funknetzgerät, insbesondere Mobiltelefon |
| 244 | optisches Erfassungssystem |
| 245, 545 | Lichtsensor |
| 546 | Sensor, insbesondere Akustiksensor |
| 247, 547 | Anzeige, insbesondere berührungsempfindlicher Bildschirm |
| 249, 549 | zweite Energieversorgungseinrichtung |
| 251 | Funkdatenübertragung |
| 555 | Entladetiefe des Akkumulators |
| 557, 557^{I} | Zykluszahl |
| 258 | Inneres, insbesondere eines Akkumulators bzw. einer Batterie |
| 560, 560', 560" | Speicher |
| 562, 562', 562" | Batteriekennwert |
| 564 | Lebenszahl, insbesondere Ladezyklenzahl |
| 566 | fester Wert, insbesondere im Sinne eine Startkonstanten |
| 567, 567', 567", 567'" | Zellenlebenszahl |
| 568 | Entladetiefensumme |
| 569 | Ladezyklenzahl |
| 570 | Lebenszähler |
| 580 | Recheneinheit, insbesondere zweite Recheneinheit |
| 581 | Bilderauswertemodul |
| 582 | Bildfolge |
| 584 | Sensorauswertemodul |
| 585 | Zeitplan |
| 586 | Berechnungsalgorithmus |
| 588 | Abbildungsvorrichtung |
| 194 | Ladeelektronik |
| 195 | Verbraucheranschlüsse bzw. Anschlüsse für Verbraucher |
| 297, 597 | Zentralstation, insbesondere Funkempfang- und Sendeeinrichtung |
| 298, 598 | Datenbank |
| 599 | Empfänger, insbesondere dislozierter Empfänger |
| H | ein hoher Pegel, insbesondere Lichtabstrahlung |
| L | ein niedriger Pegel, insbesondere keine Lichtabstrahlung |
| I | Identifikationspulsfolge mit Wert "1" |
| II | Lebenszeitübertragung mit Blinkfrequenz |
| O | Identifikationspulsfolge mit Wert "O" |
| t, t' | Zeit bzw. Zeitverlauf |
| U₁, U₂ | Zustandsmessdatum, insbesondere Spannung |
| T₁, T₂ | Zustandsmessdatum, insbesondere Temperatur |

## Patentansprüche

1. Zustandsindikator (101, 201, 501),
der zur Kontrolle eines Akkumulators (103, 103', 103", 103"', 103^{IV}, 103^{V}, 203, 203', 203", 203"', 203^{IV}, 203^{V}, 503), wie eines Bleiakkumulators, gestaltet
eine Recheneinheit (104, 204, 504, 580),
einen Taktgeber (117, 217, 517), wie einen Pulsfrequenzgenerator, und
eine Auswerteeinheit (119, 519) hat,
durch die Zustandsmessdaten, wie Temperaturmessdaten, von mindestens einer Messeinrichtung (107, 107^{I}, 107^{II}, 107^{III}, 107^{IV}, 107^{V}, 207, 207^{I}, 207^{II}, 207^{III}, 207^{IV}, 207^{V}, 507, 108, 108', 108", 108'", 108^{IV}, 108^{V}, 508), die dem Akkumulator (103, 103', 103", 103'", 103^{IV}, 103^{V}, 203, 203', 203", 203"', 203^{IV}, 203^{V}, 503) zugeordnet ist, insbesondere nach einem vorgebbaren Zeitplan, auswertbar sind,
wobei der Taktgeber (117, 217, 517) mit der Recheneinheit (104, 204, 504, 580) verbunden ist,
die zur Ausführung eines Rechenprogramms (521) gestaltet ist, das aus mindestens einem abgespeicherten Batteriekennwert (562, 562', 562") und aus wenigstens einem Zustandsmessdatum (U₁, U₂, T₁, T₂) eine Lebenszahl (564) bestimmt,
**dadurch gekennzeichnet, dass**
der Zustandsindikator (101, 201, 501) mindestens eine optische oder akustische Ausgabevorrichtung (526),
die von dem Taktgeber (117, 217, 517) mit einem elektrischen Signal versorgbar ist, hat, wobei insbesondere das Rechenprogramm (521) als eine, insbesondere weitere, Lebenszahl (564) eine Ladezyklenzahl bestimmt, und
der Zustandsindikator (101, 201, 501) die, insbesondere Gesamt-, Lebenszahl (564) dem Taktgeber (117, 217, 517) als ein elektrisches Signal zur Verfügung stellen kann und
das elektrische Signal zur Ausgabevorrichtung (526) weiterleitbar ist und
mithilfe der Ausgabevorrichtung (526) an einen Empfänger (599) transmittierbar ist.

2. Zustandsindikator (101, 201, 501) nach Anspruch 1,
**dadurch gekennzeichnet, dass**
das elektrische Signal zur Bildung einer Pulsfrequenz dient,
worin die Lebenszahl (564) wandelbar ist, und
insbesondere das Rechenprogramm (521) ein mehrstufiges Rechenprogramm (521) ist.

3. Zustandsindikator (101, 201, 501) nach Anspruch 1 oder 2,
**dadurch gekennzeichnet, dass**
der Zustandsindikator (101, 201, 501) eine Spannungsherabsetzungsschaltung (516) aufweist,
über die der Zustandsindikator (101, 201, 501) von dem zu kontrollierenden Akkumulator (103, 103^{V}, 103", 103'", 103^{IV}, 103^{V}, 203, 203', 203", 203'", 203^{IV}, 203^{V}, 503) mit elektrischer Energie versorgbar ist.

4. Zustandsindikator (101, 201, 501) nach einem der vorhergehenden Ansprüche,
**dadurch gekennzeichnet, dass**
der Zustandsindikator (101, 201, 501) durch einen gleichrichtenden Vorschaltkreis (113, 213), wie eine Graetz-Schaltung, verpolungsunabhängig gestaltet ist.

5. Zustandsindikator (101, 201, 501) nach einem der vorhergehenden Ansprüche,
**dadurch gekennzeichnet, dass**
die Recheneinheit (104, 204, 504, 580) und der Taktgeber (117, 217, 517) in einem Mikrocontroller (214, 514) realisiert sind,
wobei der Mikrocontroller (214, 514) zur Aufnahme eines Wertes (562, 562^{I}, 562^{II}) eines Analog-Digitalkonverters (525) gestaltet ist,
der insbesondere für die Konvertierung einer Spannung des Akkumulators (103, 103', 103", 103"', 103^{IV}, 103^{V}, 203, 203', 203", 203"', 203^{IV}, 203^{V}, 503), vorzugsweise einer Spannung aus der Spannungsherabsetzungsschaltung (516), ausgestattet ist.

6. Zustandsindikator (101, 201, 501) nach einem der vorhergehenden Ansprüche,
**dadurch gekennzeichnet, dass**
der Zustandsindikator (101, 201, 501) einen Speicher (560, 560', 560") und einen Lebenszähler (570) hat,
von denen in dem Speicher (560, 560', 560") zu einem Beginn einer Akkumulatorlebensphase mindestens ein fester Wert (566), wie ein Datum, vorgehalten ist, und
von denen der Lebenszähler (570) zum Abrufen des festen Werts (566) gestaltet ist, und bei einem Lebenszyklenereignis, wie eine Akkumulatorenaufladung, die Recheneinheit (104, 204, 504, 580) eine Zykluszahl (557, 557^{I}) aus dem festen Wert (566) bestimmen und dem Speicher (560, 560', 560") zur Verfügung stellen kann,
wobei die Recheneinheit (104, 204, 504, 580) für eine Veränderung der Lebenszahl (564) durch Einrechnung von zu verschiedenen Zeitpunkten ermittelten Zustandsmesswerten und durch Einrechnung von der Zykluszahl (557, 557^{I}) gestaltet ist.

7. Zustandsindikator (101, 201, 501) nach einem der Ansprüche 2 bis 7,
**dadurch gekennzeichnet, dass**
die Ausgabevorrichtung (526) zur Ausgabe der Pulsfrequenz mindestens einen optischen oder akustischen Indikator, wie eine Leuchtdiode (128, 328, 428, 528; 129, 429), eine OLED-Anzeige (230), ein LC-Display, elektronisches Papier oder einen Tongeber, umfasst.

8. Zustandsindikator (101, 201, 501) nach einem der Ansprüche 6 oder 7,
**dadurch gekennzeichnet, dass**
als eine erste Messeinrichtung (107, 107', 107", 107'", 107^{IV}, 107^{V}, 207, 207', 207", 207'", 207^{IV}, 207^{V}, 507) mindestens eine Spannungsmesseinrichtung vorhanden ist, die für eine Überwachung eines Spannungsverlaufs unter Nutzung wenigstens eines Akkumulatorpols (111, 111', 111", 111"', 111^{IV}, 111^{V}, 211, 211', 211", 211"', 211^{IV}, 211^{IV}, 511) gestaltet ist, wobei die Recheneinheit (104, 204, 504, 580) für eine Bestimmung einer Entladetiefe des Akkumulators (555) unter Nutzung mindestens eines Werts der Spannungsmesseinrichtung gestaltet ist,
wobei die Entladetiefe (555) insbesondere von der Recheneinheit (104, 204, 504, 580) in einen Batteriealterungsbeitrag umrechenbar und der Batteriealterungsbeitrag auf eine in dem Speicher (560, 560', 560") vorgehaltene Batteriealterung für eine Berechnung einer Lebenszeit aufaddierbar ist und die in dem Speicher (560, 560', 560") vorgehaltene Batteriealterung mit dem neu berechneten Wert aktualisierbar ist.

9. Zustandsindikator (101, 201, 501) nach einem der vorhergehenden Ansprüche 6 bis 8,
**dadurch gekennzeichnet, dass**
eine zweite Messeinrichtung (108, 108', 108", 108"', 108^{IV}, 108^{V}, 508) eine Temperaturmesseinrichtung ist,
wobei insbesondere eine Temperaturmesswertfolge messbar ist,
in der Temperaturmesswerte und eine Zeit, wie eine Anzahl von Stunden zwischen zwei Temperaturmessungen, für eine Berechnung einer Lebenszeit bereitstehen, wobei insbesondere durch die Recheneinheit (104, 204, 504, 580) durch temperaturabhängige Gewichtung der Zeit zwischen zwei Temperaturmessungen ein Batteriealterungsbeitrag berechenbar und der Batteriealterungsbeitrag auf eine in dem Speicher (560, 560^{I}, 560") vorgehaltene zweite Batteriealterung für eine Berechnung der Lebenszeit aufaddierbar ist und die in dem Speicher (560, 560^{I}, 560^{II}) vorgehaltene zweite Batteriealterung mit dem neu berechneten Wert aktualisierbar ist.

10. Zustandsindikator (101, 201, 501) nach einem der vorhergehenden Ansprüche,
**dadurch gekennzeichnet, dass**
die Lebenszahl ein Summenwert aus einem Ladezyklenzählerstand und einer Ladezyklenzahl (569) ist, die aus einer Ladezyklenprognose, die aus mindestens einer Zustandsmessung errechnet ist, berechnet ist.

11. Zustandsindikator (101, 201, 501) nach einem der Ansprüche 1 bis 10,
**dadurch gekennzeichnet, dass**
die Lebenszahl (564) eine Differenz zwischen einer, der Recheneinheit (104, 204, 504, 580) bekannten, Maximalladezyklenzahl und einer prognostizierten, aus einem Ladezyklenzählerstand berechneten Ladezyklenzahl (569) ist, wobei in eine Berechnung der prognostizierten Ladezyklenzahl (569) mindestens eine Zustandsmessung und ein aktueller Ladezyklenzählerstand einbezogen sind.

12. Zustandsindikator (101, 201, 501) nach einem der vorhergehenden Ansprüche,
**dadurch gekennzeichnet, dass**
der Akkumulator (103, 103', 103", 103"', 103^{IV}, 103^{V}, 203, 203', 203", 203"', 203^{IV}, 203^{V}, 503) eine Mehrzahl von Akkumulatorzellen (512), wie Blei-Schwefelsäure-Zellen, Lithium-Zellen und/oder Lithium-Titanat-Zellen, umfasst und die Messvorrichtung für ein Messen von Zustandsmesswerten jeder einzelnen (Akkumulator-)Zelle (512) mit jeweils mindestens einem Zellenzustandssensor ausgestaltet ist,
wobei jeweils für eine Akkumulatorzelle (512) eine Zellenlebenszahl (567, 567', 567", 567"') bestimmbar ist und die Lebenszahl (564) als ein Extremwert der Zellenlebenszahlen (567, 567', 567", 567'") vorliegt und wobei insbesondere jede Zellenlebenszahl (567, 567', 567", 567"") durch die Ausgabevorrichtung (526) ausgebbar ist.

13. Kommunikationssystem (200, 500) mit einem Zustandsindikator (101, 201, 501),
das ein Erfassungssystem (541) aufweist,
das ein von einer Recheneinheit (104, 204, 504, 580) des Zustandsindikators (101, 201, 501) abgesetztes Erfassungssystem ist, wie ein optisches (244) oder akustisches Erfassungssystem,
das eine elektrische Energieversorgung aus einer von dem Zustandsindikator (101, 201, 501) kontrollierten Akkumulator (103, 103', 103", 103'", 103^{IV}, 103^{V}, 203, 203', 203", 203'", 203^{IV}, 203^{V}, 503) unabhängigen Energiequelle hat,
**dadurch gekennzeichnet, dass**
der Zustandsindikator (101, 201, 501) nach einem der vorhergehenden Ansprüche gestaltet ist,
wobei das Erfassungssystem (541) einen Sensor (245, 545, 546) und eine Anzeige (247, 547), wie eine Textbildanzeige, umfasst,
und dass die durch den Taktgeber des Zustandsindikators (101, 201, 501) bereitgestellte Signalfrequenz, vorzugsweise in einem Frequenzintervall bis zu einer Maximalfrequenz des Taktgebers, durch den Sensor detektierbar ist,
und wobei insbesondere die Signalfrequenz, vorzugsweise unter Verwendung einer Kehrwertbildung oder eines Skalierungsfaktors oder einer Umrechungsformel oder einer Tabelle in eine Lebenszeitzahl umrechenbar und durch die Anzeige (247, 547) darstellbar ist.

14. Kommunikationssystem (200, 500) nach Anspruch 13,
**dadurch gekennzeichnet, dass**
das Erfassungssystem (541) als ein tragbares Funknetzgerät, wie ein Mobiltelefon, realisiert ist, das mit der Ausgabevorrichtung (526) des Zustandsindikators (101, 201, 501), vorzugsweise durch eine optische oder akustische Datenübertragungsverbindung, verbindbar ist,
wobei insbesondere die Anzeige (247, 547) ein berührungsempfindlicher Bildschirm ist, durch den eine Funksendung, insbesondere einer Lebenszahl oder eines Abfragesignals, aus dem Funknetzgerät veranlassbar ist.

15. Kommunikationssystem (200, 500) nach einem der Ansprüche 13 oder 14,
**dadurch gekennzeichnet, dass**
das Erfassungssystem (541) eine mit einem Lichtsensor (245, 545) verbundene, optische Abbildungsvorrichtung aufweist, die eine Erfassung einer Bilderfolge ermöglicht,
wobei ein Bilderauswertemodul (581) als Komponente des Erfassungssystems (541) vorhanden ist, das eine Blinkfrequenz (332, 432) einer ersten Leuchtdiode (128, 328, 428, 528) des Zustandsindikators (101, 201, 501) erkennt und insbesondere das Bilderauswertemodul (581) mindestens eine weitere zu erfassende Blinkfrequenz (433) mindestens einer weiteren Leuchtdiode (129, 429) unterscheiden kann,
wobei vorzugsweise die erste Blinkfrequenz (332, 432) und die weitere Blinkfrequenz (433) in einer gleichen Bilderfolge vorliegen.

16. Kommunikationssystem (200, 500) nach einem der Ansprüche 13 bis 15,
**dadurch gekennzeichnet, dass**
der Zustandsindikator (101, 201, 501) ein erstes GHz-Transceivermodul (205, 505, 210) für Frequenzen zwischen 2 GHz und 10 GHz, insbesondere in einem Bluetooth-Übertragungsband, aufweist und die Recheneinheit (104, 204, 504, 580) mit dem Transceiver in Verbindung steht, wodurch Funkdaten empfangbar sind,
wobei insbesondere das Erfassungssystem (541) mit einem zweiten GHz-Transceivermodul ausgestattet ist, das vorzugsweise eine gleiche Frequenz und ein gleiches Datenprotokoll verwendet wie das erste GHz-Transceivermodul.

17. Verfahren zur Zustandsindikation eines Akkumulators (103, 103', 103", 103"', 103IV, 103V, 203, 203', 203", 203'", 203IV, 203V, 503), wie einem Blei-Gel-Akkumulator, wie einem Lithium-Ionen-Akkumulator oder einem Lithium-Titanat-Akkumulator,
durch das Informationen für die Einschätzung einer Eignung des Akkumulators (103, 103', 103", 103'", 103IV, 103V, 203, 203', 203", 203"', 203IV, 203V, 503) für einen weiteren Betrieb ermittelbar ist,
**dadurch gekennzeichnet, dass**
ein Zustandsindikator (101, 201, 501), insbesondere nach einem der Ansprüche 1 bis 12, vorzugsweise eingebunden in ein Kommunikationssystem (200, 500) nach einem der Ansprüche 13 bis 16,
mindestens eine optische und/oder akustische Ausgabevorrichtung (526) und eine Messeinrichtung (107, 107I, 107II, 107III, 107IV, 107V, 207, 207I, 207II, 207III, 207IV, 207V, 507, 108, 108', 108", 108'", 108IV, 108V, 508) hat, durch die der Akkumulator (103, 103', 103", 103'", 103IV, 103V, 203, 203', 203", 203'", 203IV, 203V, 503) überwacht, ein elektrisches Signal auf Basis einer Lebenszahl (564) des Akkumulators (103, 103', 103", 103"', 103IV, 103V, 203, 203', 203", 203"', 203IV, 203V, 503) gebildet und hierbei ein Zustandsmessdatum (U₁, U₂, T₁, T₂) als eine Berechnungsgröße der Lebenszahl (564) übertragen wird.
